# DEMANDE DE BREVET EUROPEEN

(11) **EP 4 060 468 A1**
(43) Date de publication de la demande: **21.09.2022**
(21) Numéro de dépôt: 21163228.6
(22) Date de dépôt: 17.03.2021
(51) Int. Cl.: G06F 3/0482, G06F 3/0484, G06F 30/12

(54) **PROCÉDÉ POUR METTRE EN OEUVRE UNE OPÉRATION GRAPHIQUE SUR UN GROUPE D'OBJETS GRAPHIQUES, SYSTÈME INFORMATIQUE METTANT EN OEUVRE LEDIT PROCÉDÉ**

(71) Demandeur: EYE-Technocentre Henri Fabre, 13700 MARIGNANE (FR)
(72) Inventeur: SCHNEITER, Romain, 13005 Marseille (FR); BOURDILLON, Rémi, 13111 Coudoux (FR)
(74) Mandataire: Med'inVent Consulting

(57) **Abrégé**

L'invention concerne un procédé pour mettre en œuvre une opération graphique (F1, Fk, Fm) sur un premier objet graphique (Oi) parmi une pluralité d'objets graphiques (O1, O2, Oi, Oj, ON) affichés conjointement par une interface homme-machine de sortie (12) d'un système informatique (1), ledit procédé (100) étant mis en œuvre par une unité de traitement (10) dudit système informatique (1). Un tel procédé (100) comporte une étape (130) pour rechercher si un premier objet graphique (Oi) appartient à un groupe d'objets graphiques (GOi) par la mise en œuvre d'une opération géométrique portant sur les projections des objets graphiques selon un axe gravitationnel. Un utilisateur (U) d'un logiciel mettant en œuvre un tel procédé (100) dispose d'une aide continue et adaptative dans l'édition d'un contenu numérique (CN) s'appuyant sur des principes appartenant à la physique et au quotidien dudit utilisateur (U).

## Description

L'invention concerne un procédé pour appliquer une ou plusieurs opérations graphiques à des objets graphiques constituant collectivement un contenu numérique. Un tel contenu numérique est destiné à être perçu par un humain, au moyen d'une interface homme-machine de sortie telle qu'un écran d'ordinateur ou tout autre moyen équivalent. Un tel contenu numérique peut également être édité au moyen d'une interface homme-machine d'entrée telle qu'un dispositif de pointage et/ou un clavier d'ordinateur, voire encore un écran tactile d'ordinateur ou d'un objet électronique nomade. Lesdites opérations graphiques qu'un éditeur humain souhaite appliquer à des objets graphiques sont, de manière non exhaustive, des opérations visant à déplacer, redimensionner, dupliquer, effacer, colorer de tels objets graphiques. Ces derniers s'apparentent généralement à des formes géométriques en deux ou trois dimensions, des blocs de textes ou à des images.

Le domaine de l'invention est notamment celui des logiciels de dessin ou de conception numérique. De manière non exhaustive, nous pouvons citer les solutions « Powerpoint » de Microsoft, la suite « Créative » d'Adobe ou encore « Keynote » d'Apple. Comme évoqué précédemment, ces outils informatiques offrent une multitude de fonctions permettant à un utilisateur, quel que soit son expertise en matière de dessins, de constituer, avec plus ou moins d'aisance ou de productivité, des présentations ou des contenus numériques comportant une pluralité d'objets graphiques tels que des formes géométriques de base comme des ronds, carrés, rectangles, flèches, disques ou encore des formes plus sophistiquées, des textes de différentes polices de caractères sur fonds opaques ou translucides, des images importées, etc.

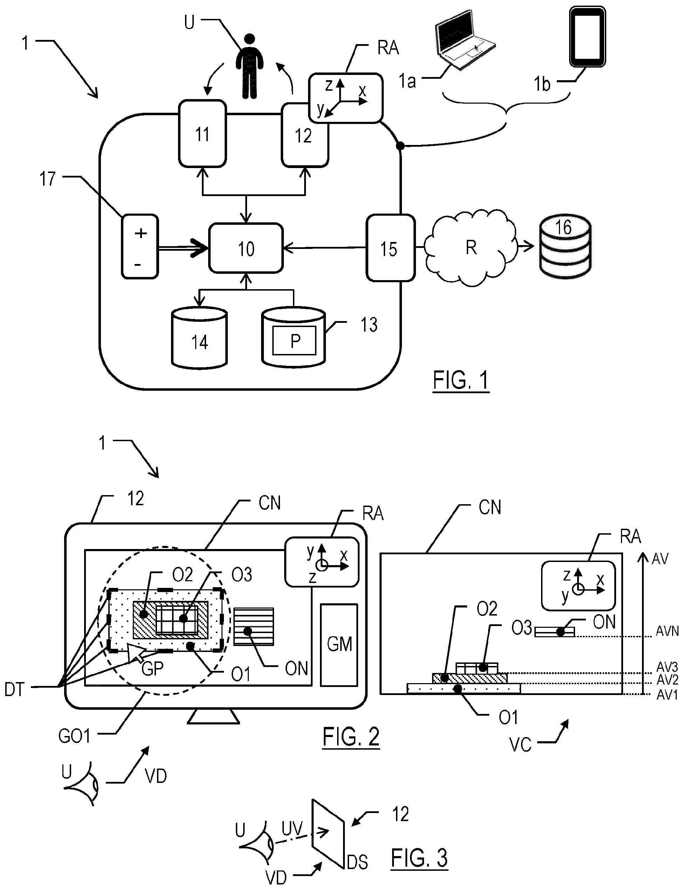

Comme l'indique à titre d'exemple la figure 1, un utilisateur U d'un ordinateur la ou d'un objet électronique mobile 1b ou plus généralement d'un système informatique 1, peut interagir avec un tel logiciel P pour constituer un contenu numérique au moyen d'une interface homme-machine d'entrée 11. Cette dernière peut être simple ou plurielle. Elle peut ainsi consister en un clavier d'ordinateur, un dispositif de pointage tel qu'une souris informatique ou un pavé tactile, un microphone. Une telle interface homme-machine d'entrée 11 peut consister, plus généralement, en tout équipement électronique permettant de traduire une gestuelle ou un son émis par un humain en données numériques de commande ou de consignes exploitables par une unité de traitement 10 dudit système informatique 1. Réciproquement, ce dernier comporte une interface homme-machine de sortie 12 pour délivrer ou sortir un tel contenu numérique de sorte que celui-ci soit perceptible par un humain. Une telle interface homme-machine de sortie 12 peut être simple ou plurielle et consister en un écran d'ordinateur, un haut-parleur, un projecteur d'images sur un écran tiers. Parfois, lesdites interfaces homme-machine d'entrée 11 et de sortie 12 peuvent ne constituer qu'une seule et même entité physique. C'est le cas, par exemple, d'un écran tactile d'ordinateur ou d'un objet électronique mobile tel qu'un ordinateur portable la, une tablette interactive ou un téléphone mobile intelligent 1b. Des contenus numériques, préalablement enregistrés dans une mémoire de données 14 du système informatique 1, peuvent ainsi être lus par l'unité de traitement 10 qui en provoque une sortie par ladite interface homme-machine de sortie 12. Une telle mémoire de données 14 consiste généralement en une ou plusieurs mémoires vives, de technologies DRAM, SRAM, SDRAM, amovibles ou non. Une telle mémoire de données 14 peut en outre s'appuyer sur toute autre technologie permettant d'enregistrer avantageusement de manière réversible de tels contenus numériques.

Une unité de traitement 10, d'un système informatique 1 selon la figure 1, peut consister en un processeur unique, une pluralité de processeurs ou en une combinaison de ceux-ci. Certains systèmes informatiques 1 peuvent comporter une unité de traitement 10 comprenant un ou plusieurs « cœurs » de processeur. L'unité de traitement 10 peut être connectée à une infrastructure de communication 15, telle qu'un bus, une file d'attente de messages, un réseau, un système de transmission de messages, etc. Un tel réseau R peut être tout réseau adapté à l'exécution des fonctions décrites dans le présent document et peut comprendre un réseau local étendu filaire ou sans fil, un réseau de communication mobile, un réseau satellite, l'Internet, etc. ou toute combinaison de ceux-ci permettant d'interagir avec une entité électronique distante 16.

Pour adapter le comportement d'un tel système informatique 1, ce dernier comporte généralement une mémoire de programmes 13 comportant un ou plusieurs programmes informatiques ou logiciels, c'est-à-dire un ou plusieurs ensembles d'instructions exécutables par l'unité de traitement 10. Une telle mémoire de programmes 13 peut consister, par exemple, en une ou plusieurs mémoires vives (par exemple, DRAM, SRAM) et/ou mortes (par exemple, EEPROM, PROM, etc.). A l'instar de la mémoire de données 14, la mémoire de programmes 13 peut comporter une ou plusieurs unités de stockage amovibles ou non telles qu'un disque dur, un lecteur de disques optiques, des supports de mémoire flash, etc. Une telle unité de stockage peut être un support d'enregistrement non transitoire lisible par ordinateur. Les termes « support de programme informatique », « support lisible par ordinateur non transitoire » et « support utilisable par ordinateur » utilisés dans le présent document, font généralement référence à des supports tangibles tels qu'une unité de stockage inamovible ou amovible, un disque dur classique ou de type SSD pour Solid-State Drive selon une terminologie anglo-saxonne. Un tel système informatique 1 comporte en outre une ou plusieurs sources en énergie électrique 17 internes ou externes pour délivrer l'énergie nécessaire au fonctionnement des organes électroniques évoqués précédemment.

Comme l'indique la figure 2, lorsqu'un utilisateur U d'un système informatique 1 tel que celui décrit en liaison avec la figure 1, ce dernier comportant dans une mémoire de programmes 13 un programme d'ordinateur P de dessins ou de conception numérique, souhaite créer un contenu numérique graphique CN, ledit utilisateur U crée tout d'abord un contenu vierge ou d'ores et déjà agencé selon une charte graphique déterminée. Un tel contenu numérique CN peut être affichable et éditable en deux ou trois dimensions selon un référentiel d'affichage déterminé RA comprenant deux ou trois axes x, y et z, normaux entre eux.

A l'aide d'un menu graphique GM disponible via l'interface homme-machine de sortie 12, l'utilisateur U peut sélectionner, via l'interface homme-machine d'entrée 11, un type d'objet graphique qu'il souhaite insérer dans ledit contenu numérique. A l'aide d'un pointeur graphique GP positionné par l'utilisateur U, via l'interface homme-machine d'entrée 11, ledit utilisateur U choisit la position du centre de l'objet graphique qu'il souhaite insérer. Lors de la réception d'une donnée de confirmation de pointage, découlant par exemple d'un bref clic de souris ou d'un bref contact d'un doigt sur un écran tactile, ladite donnée de confirmation de pointage étant délivrée par ladite interface homme-machine d'entrée 11, la position du centre de l'objet graphique est déterminée. L'objet graphique est généralement inséré selon des dimensions et/ou caractéristiques graphiques déterminées par défaut ou par paramétrage. L'utilisateur U peut alors modifier les dimensions ou, plus généralement, les caractéristiques graphiques de l'objet graphique qu'il vient de positionner.

Un tel utilisateur U peut également modifier des caractéristiques d'un objet graphique d'ores et déjà inséré dans le contenu numérique CN. Dans ce cas, en lieu et place d'une insertion d'un objet graphique, l'utilisateur U sélectionne un objet graphique du contenu numérique parmi les objets O1, O2, O3 à ON composant le contenu numérique CN illustré par la figure 2. Il lui suffit pour cela de positionner le pointeur graphique GP sur l'objet graphique qu'il souhaite sélectionner et de provoquer l'émission d'une donnée de confirmation de pointage, par exemple un bref clic de souris, délivrée par ladite interface homme-machine d'entrée 11. L'objet graphique est alors sélectionné. Les coordonnées graphique du pointeur graphique lors de la réception de la donnée de confirmation de pointage constitue une première donnée d'entrée UE1 de l'utilisateur U. Ainsi, l'objet 01 sur la figure 2 a été sélectionné par l'utilisateur. Ledit objet graphique 01 apparaît doté de poignées ou de taquets de dimensionnement DT qui permettra à l'utilisateur U de modifier les dimensions de l'objet s'il le souhaite. Lesdites poignées DT permettent en outre à l'utilisateur U de distinguer visuellement un objet graphique Oi sélectionné des autres objets Oj d'un contenu graphique CN. Dès qu'un premier objet graphique Oi (l'objet Oi=O1 sur ledit exemple de la figure 2) vient d'être inséré ou sélectionné, l'utilisateur U peut désigner un type d'opération ou de transformation graphique F1, F2, ..., Fk à Fm qu'il souhaite appliquer à ce premier objet graphique Oi. Selon les logiciels actuellement disponibles, cette désignation est généralement réalisée par la sélection, via un pointeur graphique GP déplacé à l'aide de l'interface homme-machine d'entrée 11, d'un item d'un menu graphique GM présentant les différentes opérations graphiques disponibles. Lesdites coordonnées du pointeur graphique GP, lors de la réception d'une données de confirmation de pointage en lien avec l'un des items sélectionnables du menu GM, constituent collectivement une deuxième donnée d'entrée UE2 interprétée par l'unité de traitement 10 comme moyen de désignation d'une opération graphique à appliquer. Cette désignation étant faite, l'utilisateur U peut positionner le pointeur graphique GP sur un nouveau menu graphique lui présentant un panel de couleurs, de textures de fond et/ou de bordure disponibles, de manipulations dans l'espace de l'objet graphique sélectionné, etc. Comme évoqué précédemment, généralement un objet graphique sélectionné ou nouvellement inséré Oi comporte sur son enveloppe des poignées ou des taquets graphiques DT permettant, lorsqu'elles ou ils sont pointés par l'utilisateur U, via l'interface homme-machine d'entrée 11, de traduire la volonté dudit utilisateur U d'étirer ou de compresser certaines dimensions caractéristiques de l'objet graphique Oi, par exemple sa longueur, son diamètre, sa largeur ou sa profondeur, etc. La sélection d'une telle poignée graphique DT constitue un deuxième exemple d'une deuxième entrée UE2 de l'utilisateur U pour désigner l'opération graphique de transformation à appliquer à l'objet graphique sélectionné. Une nouvelle sortie ou affichage du contenu numérique CN est automatiquement et continuellement provoquée par l'unité de traitement 10 du système informatique 1 pour que l'utilisateur U puisse constater le résultat de l'application de l'opération graphique Fk qu'il a désignée. De multiples opérations graphiques peuvent ainsi être désignées par l'utilisateur U pour être appliquées à un objet graphique préalablement sélectionné.

Lorsqu'une multitude d'objets a été insérée ou transformée par l'utilisateur U, ce dernier doit rapidement être guidé, c'est-à-dire renseigné de manière permanente et efficace par le logiciel dans son travail d'édition. Ainsi, comme l'indique la figure 2, un utilisateur U a d'ores et déjà inséré un premier objet graphique O1, un deuxième objet graphique O2, un troisième objet graphique O3 puis enfin un n^{ième} objet graphique ON. Nous pouvons constater que les différents objets graphiques O1, O2, O3 et ON ont des textures ou motifs différents pour faciliter leur distinction dans le présent document. La figure 2 présente un contenu numérique CN vu de dessus. Le référentiel d'affichage RA est tel que l'axe z et l'axe de vision (normal à la surface d'affichage DS de l'interface homme-machine de sortie 12) de l'utilisateur U sont parallèles selon des directions opposées. Un tel axe de vision UV de l'utilisateur U est décrit par la figure 3 au regard de la surface d'affichage DS d'une interface homme-machine de sortie 12 telle qu'un écran d'ordinateur la. Ainsi, en lien avec la figure 2, l'objet graphique O3 inséré postérieurement à l'objet graphique O2 apparaît, selon la vue VD illustrée par la figure 2, comme étant plus proche des yeux de l'utilisateur U que l'objet graphique O2, lui-même inséré postérieurement à l'objet graphique O1. C'est pour cela que l'objet graphique O2 recouvre en partie l'objet graphique O1. Il en est de même pour l'objet graphique O3 qui recouvre partiellement l'objet graphique O2.

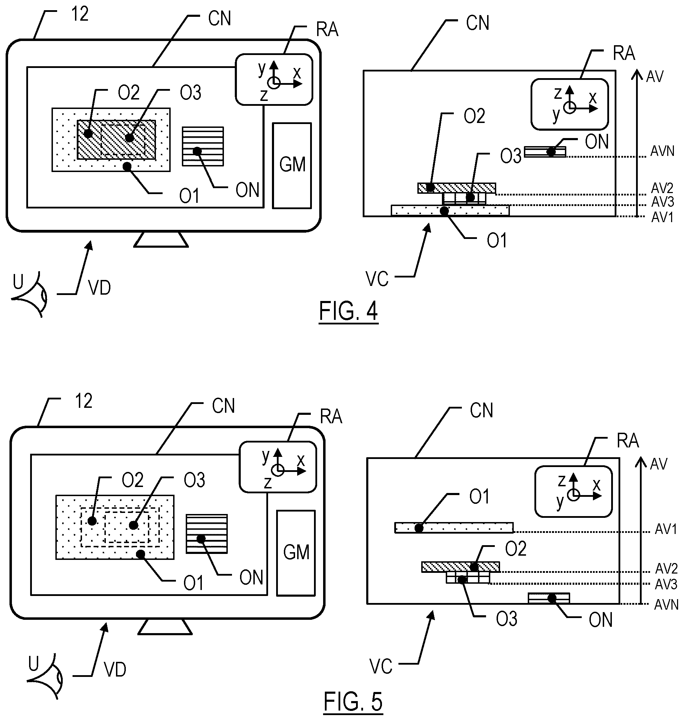

Selon que l'utilisateur U souhaite modifier les règles de recouvrement entre lesdits objets graphiques O1 à ON, il devient nécessaire d'indiquer au logiciel de dessins quel premier objet graphique Oi déplacé ou inséré peut recouvrir un deuxième objet graphique Oj ou peut se glisser en dessous de ce dernier. Certains logiciels P ont fait le choix d'associer une « altitude virtuelle », référencée AV sur la figure 2, à chaque objet graphique O1 à ON, selon sa date ou chronologie d'insertion dans le contenu numérique CN. Ainsi, comme l'indique la figure 2, selon une vue théorique en coupe VC, une telle vue étant qualifiée de théorique car non disponible visuellement pour l'utilisateur U. Elle est toutefois utile à des fins « pédagogiques » dans le présent document pour illustrer le fonctionnement du logiciel P. Un premier objet graphique O1 inséré se verra associé à une altitude ou indice AV1 de valeur systématiquement inférieure à celle de l'altitude virtuelle AV2, AV3 ou AVN affectée à un deuxième objet graphique, par exemple l'objet O2, O3 ou ON, inséré après l'objet O1. Tout nouvel objet graphique inséré après l'objet O1 pourra donc recouvrir partiellement ou totalement ledit objet graphique O1. Cette situation est illustrée par la figure 2 qui décrit, via la vue en coupe VC, le contenu numérique CN. L'ordre d'insertion des objets graphiques O1 à ON permet ainsi à l'objet graphique O2 de recouvrir l'objet graphique O1, lui-même pouvant être recouvert par l'objet graphique O3. Quand bien même l'utilisateur U aurait choisi de positionner l'objet graphique ON de sorte que celui-ci ne recouvre aucun des autres objets graphiques O1, O2 et O3, l'objet graphique ON dispose de la plus haute altitude virtuelle AVN. Il est ainsi représenté sur la coupe VC comme « en suspension » ou « en lévitation » et donc apte à pouvoir recouvrir tout autre objet graphique du contenu numérique CN. Selon la vue VC de la figure 2, l'axe y et l'axe de vision du lecteur sont parallèles et de même direction. Ce type de fonctionnement du logiciel P présente toutefois des limites ergonomiques. En effet, après avoir inséré un grand nombre d'objets graphiques, il n'est plus simple du tout pour l'utilisateur U de connaître ou d'anticiper un tel ordre d'insertion ou d'appréhender les altitudes virtuelles AV associées aux différents objets graphiques O1 à ON pour que les superpositions futures ou éventuelles respectent ses attentes. Lesdites altitudes virtuelles AV ne sont généralement pas disponibles ou perceptibles pour l'utilisateur U. Ce dernier doit ainsi tâtonner et multiplier les actions de déplacements ou de duplications d'objets graphiques pour modifier la hiérarchie de superposition desdits objets graphiques formant son contenu numérique. Comme évoqué précédemment, les altitudes virtuelles affectés aux objets graphiques, référencées AV1 à AVN sur la figure 2, sont généralement initialisés selon l'ordre d'insertion des objets graphiques dans le contenu numérique. Elles peuvent toutefois être modifiées manuellement par l'utilisateur U en sélectionnant un objet graphique en particulier et en appliquant, via un menu graphique GM dédié, une opération visant à incrémenter ou décrémenter ledit indice d'affichage ou ladite altitude virtuelle AV dudit objet graphique. Le logiciel P doit ainsi prévoir et offrir des commandes spécifiques visant à artificiellement « éloigner ou rapprocher » un objet graphique de la surface d'affichage DS de l'interface homme-machine de sortie 12. Si l'utilisateur U décide de « rapprocher » de lui l'objet graphique O2, une opération manuelle dédiée, via un menu graphique GM, lui permet d'incrémenter l'altitude virtuelle AV2 de l'objet O2, de sorte que celle-ci soit plus grande que celle AV3 de l'objet graphique O3. Ledit objet graphique O3 pourra être masqué ou partiellement recouvert par l'objet graphique O2, selon leurs dimensions respectives. Cette situation est illustrée par la figure 4 qui, à l'instar de la figure 2, présente une vue de dessus VD d'un contenu numérique CN et une vue en coupe théorique VC pour illustrer notre propos. Ladite figure 4 reprend l'exemple décrit par la figure 2, alors que l'utilisateur U a modifié manuellement les altitudes virtuelles AV1 à AVN des différents objets graphiques O1 à ON, de sorte que celles-ci ne reflètent plus l'ordre d'insertion desdits objets graphiques dans le contenu numérique CN. Comme l'indique la figure 5, de mêmes nature et agencement que les figures 2 et 4, l'utilisateur U peut décider également de mettre au premier plan l'objet graphique O1 et de repousser au plus loin l'objet graphique ON. A l'issue de ces opérations de modifications d'altitudes AV, les figures 4 et 5 décrivent le résultat visuel du contenu numérique CN délivré à l'utilisateur U par l'interface de sortie 12. Nous pouvons remarquer sur la figure 5, que l'objet graphique ON pourra être potentiellement recouvert par tous les autres objets graphiques O1 à O3 lors d'une éventuelle opération graphique appliquée auxdits objets visant à modifier les positions relatives de ces derniers dans le référentiel d'affichage RA. La vue VC de la figure 5 décrit toutefois une « vision » des altitudes virtuelles AV qui devient intellectuellement peu lisible et concrète pour l'utilisateur U qui, nous le rappelons, ne peut percevoir directement une telle vue VC. Ces opérations de modifications d'altitudes AV sont en outre extrêmement fastidieuses pour l'utilisateur U car lui imposent un grand nombre d'opérations manuelles non intuitives de sélection d'objets graphiques et de commandes à exécuter. Elles ne sont pas ergonomiques et intuitives car ledit utilisateur U ne dispose que de la vue VD, c'est-à-dire la vue « de dessus ». Rapidement, ledit utilisateur U ne maîtrise plus les altitudes relatives AV1 à AVN. Son travail est ainsi fortement ralenti. En outre, les traitements mis en œuvre par l'unité de traitement 10, c'est-à-dire la conception et l'agencement du logiciel P, sont rendus complexes pour modifier et/ou maintenir la cohérence des altitudes relatives associées à tous les objets graphiques, la modification de l'une entraînant des modifications en chaîne des autres altitudes virtuelles. Il en est de même, lors de l'application d'opérations graphiques de déplacement par exemple, de nombreuses opérations étant mises en œuvre, par l'unité de traitement 10, pour déterminer « quel objet graphique doit pouvoir recouvrir tel autre ».

D'autres logiciels ont choisi de recourir à différentes feuilles de calques ou couches numériques translucides pour constituer un contenu numérique. Les objets graphiques insérés sur une même feuille de calque partagent le même indice d'affichage ou altitude virtuelle. L'ordre des feuilles de calques peut être modifié mais s'impose à tous les objets graphiques associés à une même feuille de calque numérique. Le contenu numérique s'apparente ainsi à une pluralité de couches ou feuilles de calque qui sont superposées pour constituer le rendu final du contenu numérique. Toutefois, sur une même feuille de calque le problème de superposition entre deux objets demeure ou engendre autant de feuilles de calque que d'objets graphiques susceptibles de recouvrir un autre objet, rendant le travail de l'utilisateur U et la tâche de mise en œuvre du logiciel particulièrement complexes et fastidieuses. L'utilisateur U doit régulièrement parcourir les différents feuilles de calques numériques pour réaliser l'agencement de contenu numérique, démultipliant le nombre d'entrées qu'il doit produire à cette fin et donc le nombre de données traduisant de telles entrées délivrées par l'interface homme-machine d'entrée 11 que doit interpréter le logiciel et, par voie de conséquence, l'unité de traitement 10, pour mettre en œuvre les consignes dudit utilisateur U.

Quel que soit le logiciel de dessin ou de conception numérique considéré, un utilisateur U veut pouvoir également appliquer une même opération graphique à un ensemble d'objets graphiques, factorisant ainsi certaines opérations manuelles et chronophages. Par exemple, il peut souhaiter colorer plusieurs objets graphiques en une seule opération ou encore déplacer concomitamment plusieurs objets graphiques, ces derniers formant un assemblage ou groupe d'objets graphiques dont l'un des objets graphiques dudit groupe est pointé par l'utilisateur U via l'interface homme-machine d'entrée 11. Cette situation est illustrée par la figure 2. Dès qu'un groupe d'objets graphiques, par exemple le groupe GO1, est constitué manuellement par ledit utilisateur U, il devient possible de factoriser une ou plusieurs opérations graphiques sur l'ensemble des objets graphiques format ledit groupe GO1. A l'instar des problèmes liés à la gestion des recouvrements ou superpositions d'objets graphiques évoquée précédemment, la constitution de groupes d'objets demeure, avec les solutions actuelles, une opération manuelle fastidieuse, chronophage et peu intuitive pour l'utilisateur. Une telle gestion de groupe nécessite en outre de complexifier le logiciel pour offrir une telle fonctionnalité de constitution de groupe assistée par les consignes dudit utilisateur. En effet, ce dernier doit réaliser une sélection multiple d'objets graphiques qu'il souhaite associer artificiellement. Il doit pour cela, pour chaque objet graphique concerné, déplacer via l'interface homme-machine d'entrée 11, un pointeur graphique GP au-dessus dudit objet graphique concerné par la constitution d'un groupe, provoquer la délivrance d'une donnée de confirmation d'un pointage multiple délivrée par ladite interface homme-machine d'entrée 11, découlant d'un clic d'une souris informatique combiné à l'actionnement d'une touche d'un clavier informatique, par exemple. Il peut, en variante, sélectionner par fenêtrage plusieurs objets graphiques, au risque de capturer dans la fenêtre de sélection des objets graphiques intrus ou non pertinents ou de laisser hors de portée de sa sélection des objets graphique pertinents. A l'issue de cette sélection peu intuitive et ergonomique, l'utilisateur U doit alors parcourir un menu graphique et désigner une opération de constitution de groupe, entraînant la création virtuelle par le logiciel d'un méta-objet graphique constitué par l'ensemble des objets graphiques précédemment sélectionnés. A l'issue de cette constitution, un groupe d'objets graphiques n'est généralement pas facilement perceptible par l'utilisateur. Nombreuses sont donc les opérations manuelles factorisées de manière malencontreuse par un utilisateur U pensant ne transformer que le seul objet graphique sélectionné et non pas un ensemble d'objets graphiques auquel ledit objet sélectionné appartient. L'utilisateur est souvent contraint d'annuler cette transformation si cette opération est réversible, demander la destruction du groupe auquel appartient l'objet graphique sélectionné, réaliser l'opération graphique désignée, puis reproduire les étapes fastidieuses de constitution du groupe dans la foulée.

La constitution d'un groupe d'objets graphiques pour appliquer collectivement à l'ensemble des objets graphiques formant un tel groupe, une même opération graphiques exige une opération spécifique et manuelle complexe et fastidieuse pour l'utilisateur U, notamment si ledit groupe doit comporter une multitude d'objets dont certains peuvent être occultés ou recouverts en grande partie ou totalement par d'autres. Cette opération nécessite une technicité accrue pour l'utilisateur U et engendre de nombreux gestes et opérations de saisie démultipliant la charge de travail pour ledit utilisateur dans sa tâche. Le logiciel doit aussi de son côté être agencé pour traduire toutes ces actions multiples complexifiant et alourdissant les traitements accomplis par l'unité de traitement informatique, mettant en œuvre ledit logiciel.

L'invention permet de résoudre les limitations évoquées précédemment en proposant une constitution naturelle et automatique de groupes d'objets graphiques préalablement à la réalisation d'opérations graphiques portant sur de tels objets ou groupes d'objets graphiques. Parmi les nombreux avantages procurés par l'invention, nous pouvons mentionner que la constitution d'un groupe d'objets graphiques ne nécessite aucune gestuelle dédiée, opération, entrée ou saisie complexe, plurielle et non intuitive de la part d'un utilisateur U. Ce dernier est déchargé de cette tâche de constitution manuelle, réduisant de manière drastique le nombre de gestes et d'opérations à réaliser dans sa tâche d'élaboration d'un contenu numérique. Tout logiciel mettant en œuvre ladite invention est ainsi allégé de toutes interprétations complexes de consignes émanant de l'utilisateur. L'invention réussit en outre le tour de force d'apporter, à l'insu dudit utilisateur et donc indépendamment de son niveau d'expertise dans la manipulation de son outil informatique, une aide crédible, car vérifiée auprès d'un panel d'utilisateurs-testeurs ayant été impliqués dans des tests d'ergonomie confidentiels, dans la saisie de ses entrées pour élaborer un contenu numérique comportant une pluralité d'objets graphiques. Ladite aide est en outre continue et adaptative au contexte lié à l'élaboration dudit contenu numérique, c'est-à-dire à l'agencement progressif dudit contenu numérique. A l'issue desdits tests confidentiels, les utilisateurs-testeurs ont manifesté spontanément le souhait de ne plus avoir recours aux actuelles solutions jugées si peu intuitives et chronophages. Ils ont même, pour beaucoup, reconnu avoir rencontré des difficultés à devoir de nouveau exploiter les solutions antérieures, découvrant des gestes et habitudes pourtant enseignés depuis fort longtemps devenus spontanément si peu intuitifs et complexes à l'issue de leur expérimentation de l'invention. Lesdits utilisateurs-testeurs ont admis avoir intégré naturellement et quasi immédiatement des réflexes simples et ergonomiques car découlant de principes liés à la physique auxquels nous sommes quotidiennement confrontés, parmi lesquels nous pouvons citer :
- l'apesanteur ou la gravité selon laquelle un objet graphique, lorsqu'il n'est plus sélectionné ou maintenu, « tombe » au sol, c'est-à-dire, en l'espèce, sur le cadre ou la marge inférieure du contenu numérique, ou sur un autre objet graphique d'ores et déjà positionné « en-dessous » de lui ;
- l'adhésion par frottement ou l'aimantation entre deux objets graphiques adjacents qui, respectivement, prévient tout glissement d'un objet porté par un autre objet graphique en cours de déplacement ou créant une attraction entre deux objets graphiques adjacents.

Les améliorations apportées par l'invention sont tangibles et mesurables. La constitution de groupes d'objets graphiques est « naturelle » et automatique selon l'agencement du contenu numérique ou, en d'autres termes, selon les positions relatives des objets graphiques dans le référentiel d'affichage RA. La détection et l'interprétation des données d'entrées ou saisies de l'utilisateur sont plus performantes et moins nombreuses que celles requises par l'exploitation des actuelles solutions connues. Les gestes de l'utilisateur sont plus rapidement et précisément reconnus par le système informatique 1 mettant en œuvre l'invention, réduisant la charge de traitement dudit système informatique pour accomplir une même opération graphique sur un ensemble d'objets graphiques au regard des solutions existantes.

A cette fin, il est prévu un procédé pour mettre en œuvre une opération graphique sur un premier objet graphique parmi une pluralité d'objets affichés conjointement par une interface homme-machine de sortie d'un système informatique, ledit procédé étant mis en œuvre par une unité de traitement dudit système informatique comportant, en outre, une interface homme-machine d'entrée. Un tel procédé comprend :
- une étape pour traduire une première entrée d'un utilisateur délivrée par l'interface homme-machine d'entrée, en sélection dudit premier objet graphique ;
- une étape pour traduire une deuxième entrée d'un utilisateur, délivrée par l'interface homme-machine d'entrée, en désignation d'une opération graphique à appliquer au premier objet graphique ;
- une étape pour rechercher si ledit premier objet appartient à un groupe d'objets graphiques parmi la pluralité d'objets graphiques conjointement affichés ;
- une étape pour appliquer ladite opération graphique désignée au groupe d'objets graphiques lorsqu'un tel groupe d'objets graphiques existe ou au seul premier objet graphique dans le cas contraire ;
- une étape pour provoquer un nouvel affichage conjoint de la pluralité des objets graphiques résultant de l'application de ladite opération graphique désignée.

Pour proposer une aide particulièrement précieuse, continue et adaptative pour l'utilisateur en simplifiant les entrées de ce dernier et simplifier la tâche d'une unité de traitement mettant en œuvre un tel procédé, ce dernier est agencé de sorte que l'étape pour rechercher si ledit premier objet graphique appartient à un groupe d'objets graphiques consiste à :
- déterminer un axe, dit « axe gravitationnel » dans un référentiel d'affichage de la pluralité d'objets graphiques affichés conjointement par l'interface homme-machine de sortie ;
- mettre en œuvre une opération géométrique portant sur les projections des premier et deuxième objets graphiques, lesdites projections étant réalisées selon l'axe gravitationnel sur un plan comprenant le ou les autres axes constituant le référentiel d'affichage et considérer, parmi la pluralité d'objets graphiques affichés conjointement, un deuxième objet graphique comme formant un groupe d'objets graphiques comportant le premier objet graphique selon le résultat de ladite opération géométrique.

Selon un premier mode de réalisation, l'opération géométrique portant sur les projections des premier et deuxième objets graphiques peut consister à déterminer si la surface définie par la projection du deuxième objet est comprise dans la surface définie par la projection du premier objet graphique, le deuxième objet graphique étant considéré comme formant un groupe d'objets graphiques comportant le premier objet graphique dans l'affirmative.

Selon un deuxième mode de réalisation, ladite opération géométrique portant sur les projections des premier et deuxième objets graphiques peut consister à déterminer si la surface définie par la projection du deuxième objet graphique est majoritairement comprise dans la surface définie par la projection du premier objet graphique, le deuxième objet graphique étant considéré comme formant un groupe d'objets graphiques comportant le premier objet graphique dans l'affirmative.

Selon un troisième mode de réalisation, ladite géométrique portant sur les projections des premier et deuxième objets graphiques peut consister à déterminer si lesdites projections partagent tout ou partie de leurs périmètres respectifs, le deuxième objet graphique étant considéré comme formant un groupe d'objets graphiques comportant le premier objet graphique dans l'affirmative.

Pour pouvoir sélectionner un objet graphique, l'invention prévoit que l'étape pour traduire une première entrée d'un utilisateur en sélection du premier objet graphique puisse consister à :
- déterminer la projection, sur un plan déterminé par la surface d'affichage de l'interface homme-machine de sortie selon un axe du référentiel d'affichage normal à ladite surface d'affichage, d'un pointeur graphique, positionné par l'utilisateur via l'interface homme-machine d'entrée, lors de la réception d'une donnée de confirmation de pointage délivrée par ladite interface homme-machine d'entrée ;
- considérer, comme premier objet graphique sélectionné, tout objet graphique dont la projection, sur ledit plan déterminé par la surface d'affichage de l'interface homme-machine de sortie selon l'axe du référentiel d'affichage normal à ladite surface d'affichage, comprend ladite projection dudit pointeur graphique sur ledit plan déterminé par la surface d'affichage.

Pour traduire aisément la volonté de l'utilisateur dans l'édition d'un contenu numérique, l'étape pour traduire une deuxième entrée d'un utilisateur en désignation d'une opération graphique peut consister à caractériser un déplacement dudit pointeur graphique dans le référentiel d'affichage alors qu'une donnée de confirmation d'action est délivrée par ladite interface homme-machine d'entrée.

Une telle étape pour traduire une deuxième entrée d'un utilisateur en désignation d'une opération graphique peut en outre consister à préalablement déterminer un type d'opération graphique à mettre en œuvre à partir d'une donnée de sélection d'action délivrée par l'interface homme-machine d'entrée.

Selon un mode de réalisation avantageux, l'application de l'opération graphique désignée au premier objet graphique sélectionné peut emporter une même application de ladite opération graphique à tout autre deuxième objet graphique formant un groupe d'objets graphiques comportant le premier objet graphique, les positions relatives entre lesdits objets graphiques formant ledit groupe étant maintenues durant l'application de ladite opération graphique.

En application des principes de gravité et d'adhérence existant dans un monde réel et ainsi favoriser l'adhésion de l'utilisateur, lorsqu'une opération graphique « déplacer » au sein du référentiel d'affichage peut être appliquée au premier objet graphique sélectionné et à tout autre deuxième objet graphique formant un groupe comportant ledit premier objet graphique, si ledit groupe existe, les positions relatives entre lesdits premier et deuxième objets formant ledit groupe sont conservées durant ledit déplacement.

Toujours dans le même objectif, une opération graphique « déplacer » selon une direction opposée à l'axe gravitationnel, peut avantageusement s'appliquer, dès que le premier objet graphique n'est plus sélectionné, audit premier objet graphique et à tout autre deuxième objet graphique formant un groupe avec celui-ci, dans la limite selon laquelle lesdits premier et/ou deuxième objets graphiques partagent une surface adjacente avec tout autre troisième objet graphique ne formant pas un tel groupe, ladite surface adjacente partagée étant normale à l'axe gravitationnel.

Pour permettre de déroger de manière temporaire à la constitution automatique de groupes d'objets graphiques et offrir à l'utilisateur la possibilité d'intervenir individuellement sur un objet graphique formant un tel groupe, l'opération géométrique portant sur les projections des premier et deuxième objets graphiques peut ne pas être mise en œuvre lorsqu'une donnée de suspension de constitution groupe est délivrée par l'interface homme-machine d'entrée.

De manière non exhaustive, l'invention prévoit que l'opération graphique puisse appartenir à un ensemble d'opérations graphiques prédéterminées comportant déplacer, redimensionner, supprimer, dupliquer, comprimer, étirer un objet graphique.

Selon un deuxième objet, l'invention concerne en outre un produit programme d'ordinateur comportant des instructions de programme qui, lorsqu'elles sont préalablement enregistrées dans une mémoire de programmes d'un système informatique comportant une unité de traitement puis exécutées ou interprétées par ladite unité de traitement, provoquent la mise en œuvre d'un procédé pour mettre en œuvre une opération graphique sur un premier objet graphique parmi une pluralité d'objets affichés conjointement par une interface homme-machine de sortie dudit système informatique conforme à l'invention.

Selon un troisième objet, l'invention concerne également un support de mémoire de données lisible par un ordinateur enregistrant les instructions d'un tel produit programme d'ordinateur.

Enfin, l'invention concerne un système informatique comportant une unité de traitement, une mémoire de programmes, une interface homme-machine d'entrée, une interface homme-machine de sortie, ladite mémoire de programmes comportant les instructions d'un produit programme d'ordinateur conforme à l'invention.

D'autres caractéristiques et avantages apparaîtront plus clairement à la lecture de la description qui suit et à l'examen des figures qui l'accompagnent parmi lesquelles :
- la figure 1, d'ores et déjà décrite, présente un exemple de système informatique mettant en œuvre l'invention ou un logiciel selon l'état de l'art ;
- la figure 2, d'ores et déjà décrite, illustre conjointement une vue de-dessus, délivrée par une interface homme-machine de sortie, d'un contenu numérique comportant une pluralité d'objets graphiques et une vue théorique en coupe illustrant une gestion d'altitudes virtuelles préconisée selon l'état de l'art ;
- la figure 3, d'ores et déjà décrite, présente la notion d'axe de vision d'un utilisateur au regard d'une surface d'affichage d'une interface homme-machine de sortie, telle qu'un écran d'ordinateur ;
- les figures 4 et 5, d'ores et déjà décrites, illustrent respectivement des premier et deuxième exemples d'agencements d'un même contenu numérique, à l'instar de la figure 2 ;
- la figure 6 décrit un exemple d'un procédé pour mettre en œuvre une opération graphique sur un groupe d'objets graphiques selon l'invention ;
- la figure 7 illustre conjointement une vue de-dessus, délivrée par une interface homme-machine de sortie, d'un contenu numérique comportant une pluralité d'objets graphiques et une vue théorique en coupe illustrant, par comparaison avec l'état de l'art, des altitudes virtuelles d'objets graphiques gérées par un logiciel de dessin conforme à l'invention, si lesdites altitudes virtuelles étaient exploitées par l'invention à l'instar de l'art antérieur ;
- la figure 8 présente un exemple d'objet graphique affiché par une interface homme-machine de sortie d'un système informatique mettant en œuvre l'invention, après que ledit objet ait été inséré ou sélectionné dans un contenu numérique ;
- les figures 9 à 21 décrivent respectivement, à différentes étapes de mise à jour d'un contenu numérique tel que celui décrit par la figure 7, afin d'illustrer différentes constitutions automatiques de groupes d'objets graphiques, suivies de mises en œuvre d'opérations graphiques appliquées sur lesdits groupes d'objets constitués.

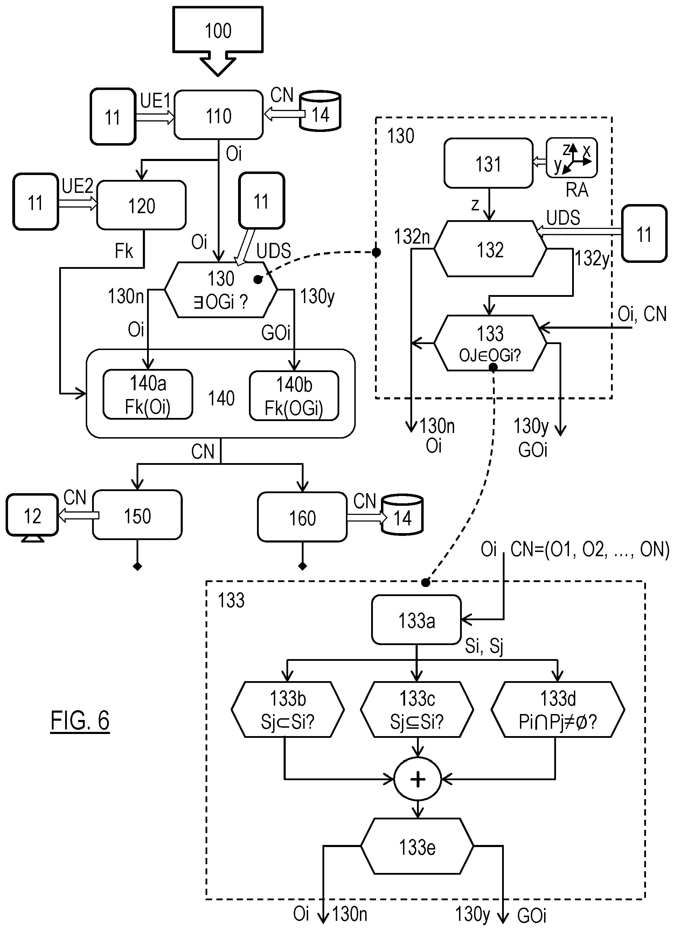

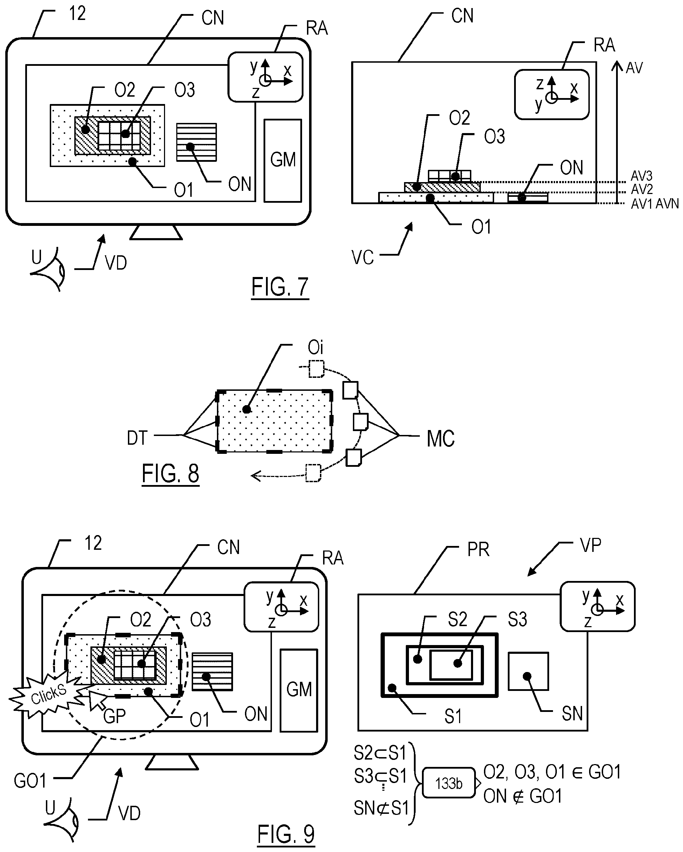

La figure 6 décrit ainsi un procédé 100 pour mettre en œuvre une opération de transformation graphique Fk parmi un ensemble de m opérations graphiques disponibles F1, F2,..., Fk,..., Fm, sur un premier objet graphique Oi parmi une pluralité de n objets graphiques O1, O2, ..., ON composant un contenu numérique CN, lesdits objets étant affichés conjointement par une interface homme-machine de sortie 12 d'un système informatique 1 tel que celui décrit en lien avec la figure 1. Un tel procédé 100 est destiné à être mis en œuvre par une unité de traitement 10 d'un tel système informatique 1 comportant en outre une interface homme-machine d'entrée 11. Ledit contenu numérique CN est quant à lui enregistré et mis à jour dans une mémoire de données 14 dudit système informatique 1. Décrivons un tel procédé 100, selon la figure 6, en liaison avec les figures 7 à 21.

La figure 7 illustre deux vues d'un contenu numérique CN pour lequel un premier objet graphique O1 est recouvert partiellement par un deuxième objet graphique O2, lui-même étant recouvert partiellement par un troisième objet graphique O3. Un n^{ième} objet graphique ON compose enfin ledit contenu numérique CN. Ledit objet graphique ON a été positionné à la droite de l'empilement formé par lesdits objets graphiques O1 à O3. La figure 7, à l'instar de la figure 2 illustrant l'état de l'art, présente, sur la gauche, une vue VD qu'un utilisateur U d'un logiciel conforme à l'invention perçoit grâce à l'interface homme-machine 12. Cette vue VD correspond à une vue de dessus du contenu numérique CN, ce dernier s'inscrivant dans un référentiel d'affichage RA comportant trois axes normaux entre eux x, y et z. Sur la vue VD, l'axe z dudit référentiel RA est parallèle à l'axe de vision UV de l'utilisateur U tel que défini par la figure 3. L'utilisateur U est donc spectateur d'une scène selon laquelle les objets graphiques O1 et ON apparaissent les plus éloignés de ses yeux, l'objet graphique O3 étant quant à lui le plus proche. Lesdits objets graphiques O1 à ON sont ainsi virtuellement disposés sur un fond, cadre ou support virtuel. La vue de gauche VD présente, en outre, un menu graphique GM offrant des items sélectionnables par ledit utilisateur U. Ladite figure 7 présente également, à des fins de comparaison avec l'état de l'art, l'équivalent des altitudes virtuelles AV1, ... AVN, respectivement associées aux différents objets graphiques O1 à ON. Contrairement aux logiciels connus, un procédé 100 selon l'invention n'exploite pas directement cette notion d'altitude virtuelle dans sa gestion des objets graphiques, notamment pour la constitution de groupes. Toutefois, cette description en coupe VC permet d'illustrer le fonctionnement de l'invention, et notamment ce qui le distingue dudit état de l'art. A titre de première différence, nous pouvons constater que lesdites altitudes virtuelles AV1 à AVN ne sont pas identiques à celles décrites en figure 2 qui illustre un même contenu graphique CN à l'issue de l'insertion des objets O1 à ON. En effet, lesdites altitudes virtuelles AV1 à AVN selon la figure 7 pourraient être celles d'objets physiques réels disposés par empilement sur une table ou un plateau, ledit plateau étant l'équivalent du fond ou cadre dudit contenu numérique CN. Les objets graphiques O1 à ON sont représentés sur la vue VC comme présentant des épaisseurs identiques par mesure de simplification. Ils pourraient toutefois disposer d'épaisseurs différentes. Les coupes desdits objets graphiques O1 à ON, dans un plan comprenant l'axe z, reprennent des motifs graphiques identiques à ceux décrivant les faces supérieures desdits objets graphiques O1 à ON présentés par la vue VD, pour faciliter la compréhension du lecteur. A l'issue de leur insertion, les objets graphiques O1 et ON partagent des altitudes virtuelles AV1, AVN nulles car lesdits objets O1 et ON sont positionnés sur le « plateau ». Les objets graphiques O2 et O3 présentent, quant à eux, des altitudes virtuelles respectives AV2 et AV3 supérieures découlant de l'empilement des objets graphiques O1 à O3. Les altitudes virtuelles AV1 à AVN apparaissent naturellement cohérentes à celles que décriraient des objets physiques si ceux-ci étaient agencés en lieu et place desdits objets graphiques O1 à ON. Selon la figure 2, la situation est tout autre. En effet, les altitudes virtuelles AV1 à AVN sont affectées aux objets graphiques O1 à ON selon la chronologie d'insertion desdits objets. Lesdites altitudes virtuelles AV1 à AVN selon la figure 2 ne décrivent pas l'équivalent d'altitudes que nous pourrions qualifier de physiques ou intuitives. En effet, il n'y aurait aucune raison liée aux lois de la physique, dont l'apesanteur ou la gravité, qui conduirait l'objet ON à demeurer « en lévitation » sous prétexte qu'il est le dernier à avoir été intégré dans le contenu numérique CN.

Un procédé 100 conforme à l'invention comporte, comme le décrit la figure 6, les étapes principales suivantes qui sont, pour la plupart, communes à l'état de l'art. En effet, pour pouvoir appliquer une opération de transformation graphique Fk à un groupe d'objets graphiques, un tel procédé 100 comporte une première étape 110 pour traduire une première entrée UE1 d'un utilisateur U, délivrée par l'interface homme-machine d'entrée 11, en sélection d'un premier objet graphique que nous référencerons par la suite Oi. Un tel objet Oi peut indistinctement correspondre à l'un des objets graphiques O1 à ON.

La figure 8 illustre un tel objet graphique Oi qui a fait l'objet d'une sélection découlant de la réception de ladite première entrée UE1. Pour produire et interpréter une telle entrée UE1, à l'instar des solutions connues, l'unité de traitement 10 d'un système 1 selon la figure 1, peut déterminer la projection d'un pointeur graphique GP sur un plan déterminé par la surface d'affichage DS de l'interface homme-machine de sortie 12 selon un axe, en l'espèce l'axe z du référentiel d'affichage RA, normal à ladite surface d'affichage DS. Un tel pointeur graphique GP a été préalablement positionné dans le référentiel d'affichage RA par l'utilisateur U via l'interface homme-machine d'entrée 11. Ladite projection dudit pointeur graphique GP est considérée lors de la réception d'une donnée de confirmation de pointage ClickS délivrée par ladite interface homme-machine d'entrée 11. Concrètement, comme le suggère la figure 9, un tel pointeur graphique GP peut être représenté par une flèche déplaçable dans le référentiel RA au moyen d'une souris informatique 11 ou d'un doigt d'un utilisateur sur une surface d'affichage tactile. La donnée de confirmation de pointage ClickS, délivrée par ladite interface homme-machine d'entrée 11, peut découler d'une brève impulsion appliquée sur une touche de la souris informatique ou d'un impact bref dudit doigt sur un écran tactile. L'unité de traitement 10 considère généralement, comme premier objet graphique sélectionné Oi, tout objet graphique dont la projection, dans ledit plan déterminé par la surface d'affichage DS de l'interface homme-machine de sortie 12, selon l'axe du référentiel d'affichage RA normal à ladite surface d'affichage DS, comprend ou inclut ladite projection dudit pointeur graphique GP dans ledit plan déterminé par la surface d'affichage DS.

Lorsqu'un objet graphique Oi est sélectionné, comme l'illustre la figure 8 et, à l'instar de l'objet O1 sur la figure 2, ledit objet graphique Oi comporte sur son pourtour ou enveloppe externe des taquets ou poignées graphique de dimensionnement DT. Lesdites poignées DT sont généralement positionnées dans les angles ou les côtés de ladite enveloppe. Les poignées situées dans les angles permettent généralement de déformer l'objet graphique Oi selon au moins deux axes du référentiel RA, contrairement aux poignées DT latérales ou longitudinales qui permettent des déformations selon un seul axe parmi les axes dudit référentiel d'affichage RA. L'invention prévoit toutefois une amélioration ergonomique notable. Bien qu'optionnelle, cette amélioration consiste à provoquer l'affichage de pictogrammes MC périphériques à l'objet graphique Oi sélectionné, lesdits pictogrammes décrivant une ou plusieurs opérations graphiques que l'utilisateur peut décider d'appliquer à l'objet graphique ou encore des paramètres de fonctionnement dudit précédé 100. Ces pictogrammes MC offrent ainsi des raccourcis ou des accès directs très appréciables sous la forme d'une alternative à la sélection d'items d'un menu graphique GM susceptible d'être affiché conjointement avec la vue VD du contenu numérique CN mais susceptible d'occulter partiellement ladite vue VD.

La figure 6 indique qu'un procédé 100, selon l'invention, comporte en outre une étape 120 pour traduire une deuxième entrée UE2 d'un utilisateur U, délivrée par l'interface homme-machine d'entrée 11, en désignation d'une opération graphique Fk à appliquer au premier objet graphique Oi ayant fait l'objet d'une sélection à l'étape 110. Une telle opération graphique Fk peut correspondre à un déplacement ou une translation dans l'espace d'affichage RA d'un objet ou d'un groupe d'objets graphiques, une déformation visant à étirer ou comprimer une dimension caractéristique, à modifier une coloration ou une texture voire à dupliquer un objet ou un groupe d'objets graphiques.

Un tel procédé 100 comporte en outre une étape 130 pour rechercher si ledit premier objet sélectionné Oi, grâce à la première entrée UE1, appartient à un groupe d'objets graphiques GOi comprenant un ou plusieurs autres objets graphiques parmi la pluralité d'objets graphiques O1, O2,..., ON conjointement affichés par l'interface homme-machine de sortie 12.

Ledit procédé 100 comporte également une étape 140 pour appliquer ladite opération graphique désignée Fk au groupe GOi d'objets graphiques lorsqu'un tel groupe d'objets graphiques existe (situation symbolisée par le lien 130y sur la figure 6) ou au seul premier objet graphique sélectionné Oi dans le cas contraire (situation symbolisée par le lien 130n sur ladite figure 6). Enfin, ledit procédé 100 comporte, à l'instar des procédés connus, une étape 150 pour provoquer un nouvel affichage conjoint de la pluralité des objets graphiques O1, O2, ..., ON, résultant de l'application de ladite opération graphique désignée Fk.

Un procédé 100 conforme à l'invention, se distingue notamment des procédés connus en ce que la constitution d'un groupe d'objets graphiques GOi ne découle pas d'une pluralité d'actions chronophages, dédiées et effectuées par l'utilisateur U mais découle automatiquement des agencements relatifs des objets graphiques réalisés au fil de l'élaboration du contenu numérique CN.

Ainsi, l'étape 130 (étape symbolisée par l'expression mathématique « ∃ GOi ? ») pour rechercher si un objet graphique, préalablement sélectionné et que nous référençons Oi sur la figure 6, appartient à un groupe d'objets graphiques GOi, consiste tout d'abord à déterminer, en une sous-étape 131, un axe, dit « axe gravitationnel ». Un tel axe gravitationnel peut être choisi parmi les axes constituant le référentiel d'affichage RA ou bien correspondre à tout autre axe au sein dudit référentiel d'affichage RA. Un tel axe gravitationnel sera avantageusement choisi pour être aligné avec l'axe de vision d'un utilisateur U de l'interface homme-machine de sortie 12. A titre d'exemple, comme le décrit la figure 9, ledit référentiel d'affichage RA comporte trois axes normaux entre eux x, y et z. Sur la vue VD dont dispose l'utilisateur U, l'axe gravitationnel déterminé est avantageusement l'axe z, ce dernier étant sensiblement parallèle à l'axe de vision dudit utilisateur. De cette manière, les objets graphiques O1 à ON sont perçus par l'utilisateur comme si celui-ci les observait par-dessus. L'invention ne saurait toutefois être limitée par ce seul choix d'axe gravitationnel z. L'axe x ou y pourrait ainsi être choisi en lieu et place de l'axe z, voire tout autre axe quelconque. Une telle détermination de l'axe gravitationnel peut découler de la valeur d'un paramètre de fonctionnement ou de préférences de l'utilisateur U. Comme l'indique la partie droite VP de la figure 9, la sous-étape 131 détermine en outre, par le choix de l'axe z, un plan de projection PR, selon ledit axe z, au sein duquel, en une sous-étape 133a, les au moins une faces respectives de chaque objet graphique O1 à ON vont être projetées. En effet, l'étape 130 comporte une sous-étape de test (symbolisée sur la figure 6 par l'expression mathématique « OJ∈ GOi ? » pour savoir si un deuxième objet graphique Oj appartient à un groupe d'objets GOi comprenant l'objet graphique sélectionné Oi. Les exemples illustrés par les figures 2 à 19, décrivent des objets graphiques O1 à ON sous la forme de pavés d'épaisseurs faibles ou négligeables. Un objet graphique Oi consiste, pour un système informatique 1 tel que celui décrit précédemment en lien avec la figure 1, en une structure de données enregistrée dans la mémoire de données 14. Ladite structure de données comporte, par exemple, des coordonnées, dans le référentiel d'affichage RA, de points d'une polyligne définissant une surface de l'objet graphique ou toutes données permettant de définir et afficher une telle surface. Ladite structure de données peut contenir toutes autres données ou attributs numériques pour caractériser, de manière non exhaustive, une texture, une couleur de fond ou de bordure, un identificateur unique pour distinguer ledit objet graphique des autres objets graphiques composant le contenu numérique CN, etc. Un groupe d'objets graphiques GOi peut, quant à lui, également être associé à une structure de données comportant des références directes ou indirectes aux objets graphiques qui le forment. En variante ou en complément, un identifiant de groupe peut être inscrit dans la structure de donnée associée à chaque objet graphique qui le forme. Toute autre méthode permettant de définir objets graphiques et/ou groupe d'objets graphiques dans la mémoire de données 14 pourrait également être exploitée sans sortir du cadre de la présente invention. Le résultat du calcul 133a des projections desdits objets graphiques O1 à ON, décrit dans le plan PR, des surfaces planes S1 à SN, sous la forme de rectangles ou de carrés dont les lignes de contour ou périmètres sont représentés avec des épaisseurs différentes pour en faciliter la discrimination visuelle par le lecteur et dont les dimensions sont celles desdits objets graphiques O1 à ON présentés sur la vue VD sur la gauche de la figure 9. L'invention ne saurait être limitée par la forme géométrique des objets graphiques O1 à ON considérés. Ces derniers pourraient décrire toutes formes géométriques dans l'espace d'affichage RA. Les surfaces S1 à SN, résultant d'une telle projection 133a, décriraient alors des surfaces planes de dimensions et de formes éventuellement différentes desdits surfaces S1 à SN présentées par la figure 9, telles que des disques, des ellipses, des triangles ou toutes autres formes qui seraient dictées par la géométrie de chacun des objets graphiques O1 à ON. Toute projection d'un objet graphique dans le plan PR peut également être définie par une polyligne dont les coordonnées des points qui la composent peuvent être inscrits dans la mémoire de données 14. L'aire capturée par une telle polyligne définit la surface Si de la projection de l'objet graphique Oi, ladite polyligne, en tant que telle, détermine le périmètre Pi de la surface Si.

L'étape 133 consiste, outre le calcul 133a des projections S1 à SN, à mettre en œuvre une opération géométrique 133b, 133c, 133d portant sur lesdites projections. Ainsi, comme l'indique la figure 6, une telle opération géométrique porte sur une première surface Si définie par l'objet graphique sélectionné Oi et sur une deuxième surface Sj définie par un deuxième objet graphique Oj du contenu numérique CN. Selon les figures 6 et 9, l'objet Oi sélectionné est l'objet graphique O1, ledit deuxième objet graphique Oj étant, tour à tour, l'objet graphique O2, O3 ... ou ON. Le résultat binaire 130n ou 130y de ladite opération géométrique 133b, 133c, 133d, répondra à la question « OJ ∈ GOi ? » posée à l'étape 130. Dans l'affirmative 130y, l'objet Oj sera considéré comme appartenant à un groupe d'objets GOi comportant le premier objet Oi. Dans la négative 130n, ledit objet Oj sera considéré comme ne faisant pas partie dudit groupe GOi. La figure 6 illustre trois exemples préférés 133b, 133c, 133d d'opérations géométriques pouvant être mises en œuvre de manière exclusive ou en combinaison.

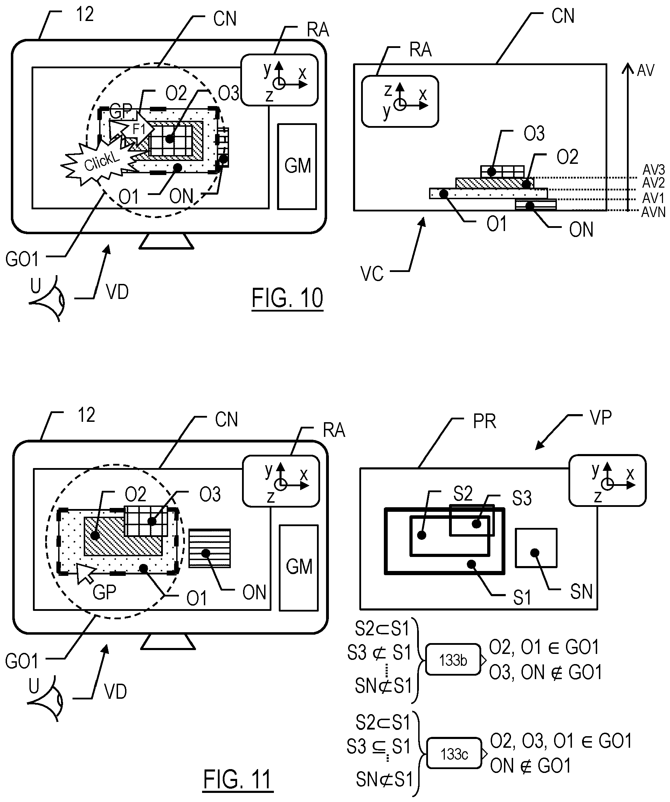

Ainsi, comme l'indique les figures 6 et 9, un premier exemple 133b d'opération géométrique 133 peut être décrit par l'expression mathématique « Si⊂sj? », soit la projection Sj est-elle incluse dans la projection Si? Dans l'exemple illustré par la figure 9, nous pouvons constater que les surfaces S2 et S3 sont respectivement incluses dans la surface 1, signifiant que les objets O1, O2 et O3 constituent collectivement un empilement d'objets graphiques et que ledit objet Oi, en l'espèce l'objet O1, « porte » ledit objet Oj, en l'espèce les objets O2 et O3. Selon cet exemple, par l'application de l'opération géométrique 133b, les objets graphiques O2 et O3 sont considérés, à l'étape 130, comme appartenant à un groupe d'objets graphiques GO1 dont fait partie l'objet graphique O1. En revanche, la projection SN définie par l'objet ON n'est pas incluse dans la projection S1. Ledit objet graphique ON ne fait donc pas partie d'un tel groupe GO1. Au sens de l'invention, comme l'indique la figure 10 qui décrit un même contenu numérique CN et des vues VD et VC similaires à celles de la figure 7, lorsqu'une première opération graphique de transformation Fk=F1 consistant à déplacer un objet ou groupe d'objets graphiques, sera appliquée en une étape 140 dudit procédé 100, le groupe d'objets GO1 suivra le déplacement de l'objet O1, comme nous le décrirons ultérieurement en lien avec ladite figure 10. L'assemblage formé par les objets graphiques O1, O2 et O3, correspondant au groupe GO1, recouvre partiellement l'objet ON à l'issue d'un déplacement vers la droite de l'objet graphique O1. En effet, lors d'une sélection de l'objet O1, l'assemblage s'élève virtuellement le long de l'axe gravitationnel z préalablement à la translation selon l'axe y proprement dite. Sous l'effet de l'opération graphique F1 de déplacement, ladite translation est effectuée puis l'assemblage repose, suivant le principe de la gravité, sur le cadre du contenu numérique CN ou sur un éventuel objet graphique tiers, en l'espèce l'objet ON. En effet, une opération graphique « déplacer » selon une direction opposée à l'axe gravitationnel z, s'applique dès que le premier objet graphique Oi n'est plus sélectionné, audit premier objet graphique Oi et à tout autre deuxième objet graphique Oj formant un groupe GOi avec celui-ci, dans la limite selon laquelle lesdits premier et/ou deuxième objets graphiques partagent une surface adjacente avec tout autre troisième objet graphique ne formant pas un tel groupe GOi, ladite surface adjacente partagée étant normale à l'axe gravitationnel z. Ce phénomène est « physiquement » logique et intuitivement compréhensible par l'utilisateur U, puisque, selon le principe de la gravité ou de l'apesanteur, l'objet graphique O1 « porte », tel un plateau, les objets graphiques O2 et O3 formant le groupe GO1 avec l'objet graphique O1. Dans un monde réel, si lesdits objets graphiques O1 à O3 étaient des objets physiques et solides, un déplacement de l'objet O1, sous la forme d'un plateau ou support, emporterait un déplacement des autres objets O2 et O3, ces derniers conservant leurs positions relatives au regard de l'objet O1. Si un utilisateur U venait à se dessaisir du plateau O1, celui-ci tomberait naturellement au sol ou sur un objet tiers en contrebas, accompagné des objets O2 et O3 qu'il supporte. Ainsi, sans que l'utilisateur U n'ait eu à constituer manuellement un tel groupe GO1, ce dernier est automatiquement constitué par le procédé 100, simplifiant les actions et entrées de l'utilisateur U et, par voie de conséquence, les traitements internes d'un logiciel P s'appuyant sur le procédé 100.

Les figures 6 et 11 illustrent une situation similaire à celle décrite précédemment en lien avec les figures 6 et 9. Le contenu numérique CN selon ladite figure 11, plus précisément par la vue VD sur la gauche de la dite figure 11, diffère uniquement du contenu numérique CN présenté par la figure 9, en ce que l'objet graphique O3 a été positionné en partie sur l'objet graphique O2 et non plus en totalité sur ledit objet graphique O2. Les figures 6 et 11 illustrent un deuxième exemple 133c d'opération géométrique 133 pouvant être décrit par l'expression mathématique « Si⊆Sj ? », soit la projection Sj est-elle majoritairement incluse dans la projection Si ? Dans l'affirmative, l'objet graphique Oj forme un groupe GOi avec l'objet graphique Oi. Dans la négative, ledit objet graphique Oj ne forme pas un tel groupe avec ledit objet graphique Oi. Selon l'exemple illustré par la figure 11, nous pouvons constater que les surfaces S2 et S3 sont respectivement majoritairement incluses dans la surface S1, signifiant que les objets O1, O2 et O3 constituent collectivement un empilement d'objets graphiques et que ledit objet Oi, en l'espèce l'objet O1, « porte » ledit objet Oj, en l'espèce les objets O2 et O3. Selon cet exemple, par l'application de l'opération géométrique 133c, les objets graphiques O2 et O3 sont considérés, à l'étape 130, comme appartenant à un groupe d'objets graphiques GO1 dont fait partie l'objet graphique O1. En revanche, la projection SN définie par l'objet ON n'est pas majoritairement incluse dans la projection S1. Ledit objet graphique ON ne fait donc pas partie d'un tel groupe GO1. Au sens de l'invention, l'opération géométrique 133c peut s'écrire sous la forme mathématique suivante Si⊆Sj si Si∩Sj ≧ Sj-(Si∩Sj) . Sous une forme littérale, on considère, au sens de l'opération géométrique 133c, que l'objet Oj est majoritairement supporté par l'objet graphique Oi, ou encore que la surface Sj est majoritairement incluse ou comprise dans la surface Si, si l'intersection desdites surfaces Si et Sj est supérieure ou égale à la surface Sj amputée de ladite intersection des surfaces Si et Sj. Comme l'indique la figure 11, la mise en œuvre de l'opération géométrique 133c conduit à considérer que les objets graphiques O1, O2 et O3 constituent un même groupe d'objets graphiques GO1 contrairement à l'objet graphique ON. Un déplacement 140 de l'objet graphique O1 entraînerait un déplacement conjugué des objets graphiques O2 et O3 mais ne concernerait pas l'objet graphique ON. Ladite figure 11 enseigne en outre que le résultat du test 130 aurait été différent par la mise en œuvre de l'opération géométrique 133b en lieu et place de l'opération géométrique 133c. En effet, le test 133b étant plus strict, seuls les objets graphiques O1 et O2 auraient formé un groupe GO1. Les objets O3 et ON en auraient été exclus. Un déplacement 140 de l'objet graphique O1 n'entraînerait, selon ladite opération géométrique 133b, qu'un déplacement conjugué du seul objet graphique O2.

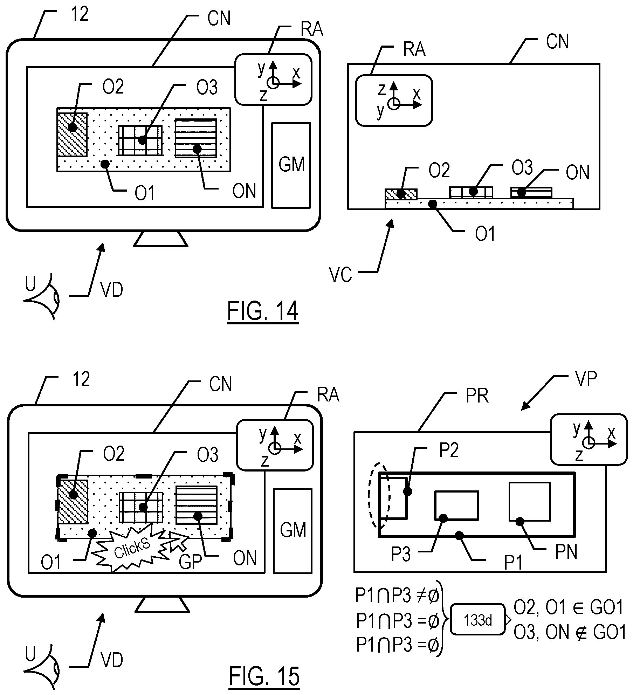

Les figures 6, 14 et 15 décrivent un troisième exemple d'opération géométrique 133d susceptible d'être mise en œuvre à l'étape 130 du procédé. Comme l'indiquent les vues VD (vue de dessus) et VC (vue en coupe) de la figure 14, un contenu numérique CN consiste en un agencement d'au moins quatre objets graphiques selon lequel un premier objet graphique O1 est recouvert partiellement par trois autres objets graphiques O2, O3, ON disjoints. Par l'application du principe de la gravité, les trois objets graphiques O2, O3 et ON partagent une même altitude virtuelle contrairement à ce que conduirait la mise en œuvre d'un logiciel selon l'état de l'art, tel que celui illustré par la figure 2.

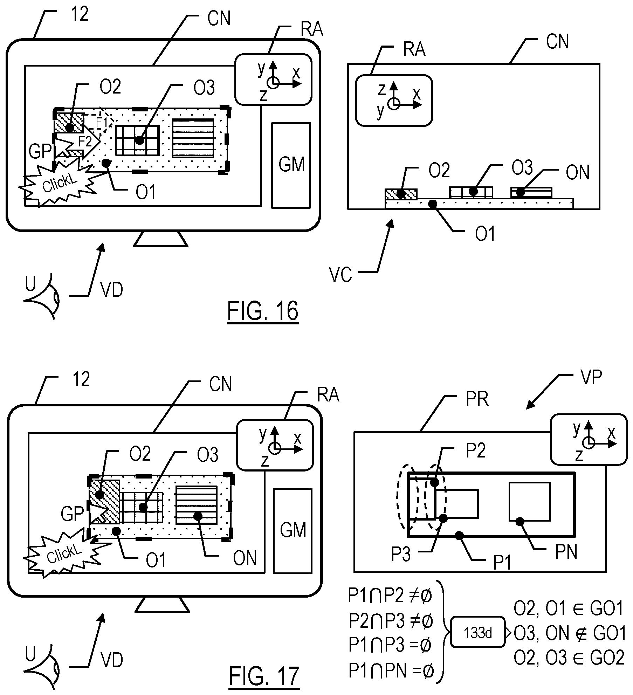

La mise en œuvre de l'opération géométrique 133d ne vise pas un objectif nécessairement similaire à celui adressé par les opérations géométriques 133b et 133c décrites précédemment. En effet, ces dernières permettent de répondre par l'affirmative 130y à un test d'appartenance à un groupe pour des premier et deuxième objets graphiques Oi et Oj, dès que la projection de l'objet Oj est majoritairement ou strictement incluse dans la projection de l'objet graphique Oj. L'opération géométrique 133d répond également par l'affirmative 130y ou la négative 130n à un test d'appartenance à un groupe pour des premier et deuxième objets graphiques Oi et Oj. Toutefois, selon cette opération géométrique 133d, un objet graphique Oj sera considéré comme formant un groupe avec l'objet graphique Oi, si les projections desdits premier et deuxième objets graphiques Oi et Oj dans le plan PR selon l'axe gravitationnel z, sont adjacentes, que l'une soit incluse ou non dans l'autre. Les projections Si et Sj respectives des objets graphiques Oi et Oj sont considérées adjacentes si leurs périmètres respectifs Pi et Pj, s'apparentant généralement à des polylignes, partagent un tronçon ou sont directement juxtaposés sur un tel tronçon. Dans la suite du présent document, les termes « tronçon partagé » de polylignes ou de périmètres de projection, désigneront, de manière indifférenciée, une section ou portion durant laquelle lesdites polylignes ou lesdits périmètres de projection sont confondus ou directement juxtaposés. La figure 15 illustre une telle situation. La vue VD dont dispose l'utilisateur U décrit la scène présentée par la figure 14, après toutefois que ledit utilisateur U ait transmis, via l'interface homme-machine d'entrée 11, une première entrée UE1 sélectionnant l'objet graphique O1. La partie droite VP de la figure 15 décrit le plan de projection PR et les projections, selon l'axe gravitationnel z, respectives d'au-moins une face de chaque objet graphique O1 à ON constituant le contenu numérique CN. Contrairement aux opérations géométriques 133b et 133c, les surfaces S1 à SN des projections des objets graphiques O1 à ON, illustrées par les figures 9 et 11, ne sont considérées en tant que telles. L'opération géométrique 133d porte sur leurs périmètres respectifs P1 à PN. La vue VP de la figure 15 illustre une situation selon laquelle les périmètres P1 et P2 des projections des objets graphiques O1 et O2 dans ledit plan PR selon l'axe z, partagent un tronçon cerclé par une ligne en pointillés. Les projections des autres objets graphiques ne présentent pas une telle caractéristique. Selon l'application de l'opération géométrique 133d, les objet graphiques O1 et O2 constituent un groupe GO1. Les deux autres objets O3 et ON n'en font pas partie. Le test mis en œuvre par une telle opération géométrique peut s'écrire sous la forme mathématique suivante « Pi∩Pj=0̸ ? » ou sous la forme littérale « les projections, dans le plan PR (défini par les axes x et y du référentiel d'affichage RA) selon l'axe gravitationnel z, de premier et deuxième objets graphiques Oi, Oj partagent-elles tout ou partie de leurs périmètres respectifs Pi, Pj ? ». Dans l'affirmative 130y, le deuxième objet graphique Oj est considéré comme formant un groupe d'objets graphiques GOi comportant le premier objet graphique Oi. Dans la négative 130n, lesdits objets graphiques Oi et Oj ne forment pas un tel groupe GOi au sens de la l'opération géométrique 133d. Cette dernière 133d peut être mise à profit dans le cadre d'une mise en œuvre 140 d'une opération graphique Fk de transformation, à l'instar des opérations géométriques 133b et 133c, telle qu'un déplacement, une duplication, un changement de texture. Nous verrons ultérieurement, en liaison avec les figures 16 à 21, que cette opération géométrique 133d trouve une application particulièrement pertinente dans le cadre d'une application 140 d'une opération graphique visant à étirer ou compresser des objets appartenant à un groupe d'objets graphiques. Comme l'indique la figure 6, les opérations géométriques 133b, 133c, 133d, voire toute autre opération géométrique portant sur des projections d'objets graphiques selon l'axe gravitationnel, peuvent être mises en œuvre de manière exclusive ou en combinaison. La sous-étape 133 peut donc comporter une opération 133e pour réaliser une combinatoire des éventuelles réponses booléennes délivrées par les opérations géométriques 133b, 133c, 133d, afin de produire la réponse affirmative 130y ou négative 130n du test 133 d'appartenance à un groupe, ainsi que la composition de ce dernier s'il existe.

Etudions à présent l'exploitation de cette notion de constitution automatique de groupes d'objets graphiques GOi lors de la mise en œuvre 140 d'une opération graphique Fk désignée par un utilisateur pour être appliquée à un objet graphique lorsque celui-ci n'appartient pas à un groupe d'objets (situation symbolisée sur la figure 6 par le lien 130n) ou audit groupe d'objets graphiques (situation symbolisée par le lien 130y sur ladite figure 6) lorsqu'un des objets appartenant audit groupe a été sélectionné à l'étape 110 comme vecteur d'application de ladite opération graphique Fk. Les figures 6, 7, 10 et 12 permettent d'illustrer les deux situations 130y et 130n.

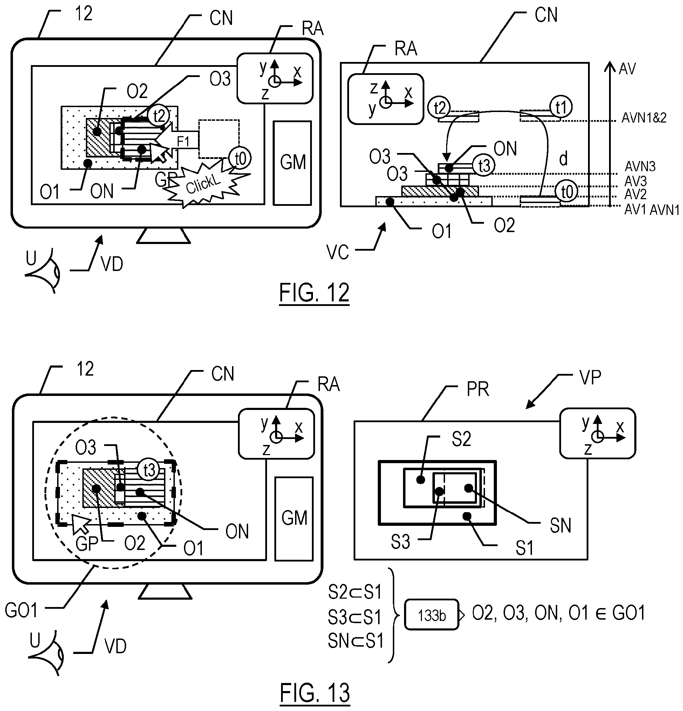

Commençons par la situation illustrée par la figure 12 qui décrit une scène identique à celle d'ores et déjà décrite en lien avec la figure 7. Selon ladite figure 12, l'utilisateur souhaite appliquer une opération graphique F1 de déplacement, au sein du référentiel d'affichage, à l'objet graphique ON. La figure 12 présente, à l'instar de ladite figure 7, une première vue VD disponible pour ledit utilisateur via la surface d'affichage DS de l'interface homme-machine de sortie 12, au travers de laquelle il peut percevoir l'agencement du contenu numérique CN vu de dessus, c'est-à-dire lorsque l'axe de vision de l'utilisateur U est sensiblement aligné avec l'axe gravitationnel z, lesdits axes étant orientés selon des directions opposées. Ladite figure 12 présente en outre une deuxième vue VC, non disponible pour l'utilisateur U. Cette vue VC décrit une coupe dudit contenu numérique CN dans un plan contenant ledit axe gravitationnel z. Nous pouvons ainsi observer les altitudes virtuelles AV1 à AVN des différents objets graphiques à différents instants t0 à t3. Ainsi, en un instant t0, l'utilisateur U sélectionne l'objet ON afin de pouvoir le déplacer dans l'espace ou référentiel d'affichage RA. Pour cela, une première entrée UE1 est exploitée, en une étape 110 du procédé 100, pour traduire cette entrée UE1 en sélection dudit objet Oi=ON. Sur la vue VD illustrée par la figure 12, ledit objet graphique ON est à présent affiché muni de poignées DT, évoquées précédemment en lien avec la figure 8. Le procédé 100 comporte alors une mise en œuvre de l'étape 130 visant à déterminer si ledit objet graphique sélectionné Oi=ON forme un groupe d'objets graphiques GOi. En une sous-étape 133a sont calculées les projections des objets graphiques du contenu numérique CN dans un plan PR normal à l'axe gravitationnel, en l'espèce l'axe z du référentiel RA sur l'exemple décrit par la figure 12. Supposons que l'opération géométrique 133 portant sur lesdites projections des objets graphiques soit l'opération 133b précédemment décrite. Il est manifeste que la surface SN résultante de la projection de l'objet ON dans ledit plan PR n'est incluse dans aucune des autres surfaces S1 à S3 définies par les projections des autres objets graphiques du contenu numérique CN. L'étape 130 conclut 130n à l'absence de groupe GOi=GON formé par l'objet graphique Oi=ON. Toute opération graphique 140a, prochainement désignée par l'utilisateur U pour être appliquée audit objet ON, ne portera que sur ce dernier.

L'utilisateur U doit à présent désigner une telle opération graphique Fk=F1 pour que celle-ci provoque, par exemple, un déplacement dudit objet ON au sein du référentiel d'affichage RA. Ledit utilisateur U dispose pour cela d'un menu graphique GM au sein duquel il peut sélectionner ladite opération graphique F1. Comme l'indique également la figure 8, l'utilisateur U peut, en variante et avantageusement, sélectionner une telle opération graphique F1 au moyen d'un des pictogrammes MC affichés, lors de la sélection dudit objet graphique ON, autour de ce dernier. De manière plus générale, l'étape 120 comporte ainsi une sous-étape préalable (non représentée en figure 6) pour déterminer un type d'opération graphique Fk à appliquer à partir d'une donnée de sélection d'action délivrée par l'interface homme-machine d'entrée 11, par exemple, via une touche déterminée d'un clavier physique ou numérique ou via la sélection d'un item ou rubrique d'un menu contextuel graphique GM présentant les types d'opérations graphiques disponibles. La mise en œuvre 140 (plus précisément 140a) d'une telle opération graphique de déplacement F1 doit en outre être caractérisée par une destination ou nouvelle position stable de l'objet graphique ON dans ledit référentiel d'affichage RA. De manière traditionnelle, l'invention prévoit que ledit pointeur graphique GP puisse être utilisé alors qu'une donnée de confirmation d'action est délivrée par l'interface homme-machine d'entrée 11. Cette combinaison d'entrées détermine ladite opération graphique de déplacement de l'objet ON. Une telle donnée de confirmation d'action, référencée ClickL sur la figure 12, peut découler d'un clic long provoqué, par exemple, par le maintien prolongé d'une touche d'une souris informatique, par une application maintenue d'un pointeur de l'utilisateur, par exemple l'un de ses doigts, s'il utilise un pavé tactile ou une interface homme-machine d'entrée et de sortie sous la forme d'un écran tactile par exemple. Le procédé 100 comporte ainsi une étape 120 pour traduire une deuxième entrée UE2 d'un tel utilisateur U en désignation d'une opération graphique Fk (Fk=F1 en figure 12) qui consiste à caractériser un déplacement dudit pointeur graphique GP dans le référentiel d'affichage RA alors qu'une donnée de confirmation d'action ClickL est délivrée par ladite interface homme-machine d'entrée 11.

Comme l'indique la figure 12, à l'instant t1, l'étape 120 provoque, lors de la réception de la donnée de confirmation d'action ClickL, le pointeur graphique GP ayant été préalablement positionné sur l'objet graphique ON, une élévation virtuelle maximale dudit objet graphique ON. En quelque sorte, ce dernier délaisse une altitude virtuelle AVN1 occupée à l'instant t0 pour occuper la plus haute altitude virtuelle possible AVN1. Tout en prolongeant la transmission de ladite donnée de confirmation d'action (par exemple, via un clic prolongé de souris informatique), l'utilisateur U provoque un déplacement du pointeur graphique GP sensiblement, selon l'exemple de la figure 12, le long de l'axe x du référentiel d'affichage RA. Une telle entrée plurielle UE2 est détectée comme désignant l'opération graphique F1 de déplacement dans le référentiel d'affichage. L'objet graphique O3 se déplace de manière liée ou conjuguée avec ledit pointeur graphique GP, jusqu'à survoler l'assemblage formé par les objets graphiques O1, O2 et O3. En effet, l'étape 120 traduit le déplacement dudit pointeur graphique GP dans le référentiel d'affichage RA, alors qu'une donnée de confirmation d'action ClickL est délivrée par ladite interface homme-machine d'entrée 11, en désignation par l'utilisateur d'une opération graphique de déplacement F1. Cette dernière est appliquée 140a au seul objet graphique ON. Ledit « survol » de l'objet graphique O3 par l'objet graphique ON est légitime puisque ce dernier occupe la plus haute altitude virtuelle AVN1. A l'instant t2, l'utilisateur U relâche sa pression sur la touche de sa souris informatique, sur le pavé tactile, encore sur l'écran tactile ou plus généralement via l'interface homme-machine d'entrée 11, ce qui provoque l'arrêt de la réception d'une donnée de confirmation d'action jusqu'alors délivrée par cette dernière. L'objet ON occupe, à l'instant t2, une nouvelle position stable au sein du référentiel d'affichage RA.

Dès que l'objet graphique ON n'est plus sélectionné (par exemple lors de la sélection d'un autre objet graphique), cet instant étant référencé t3 sur la figure 12, une opération graphique F1 de déplacement, selon une direction opposée à l'axe gravitationnel z, est automatiquement appliquée audit objet graphique ON. Un tel déplacement automatique cesse dès que l'objet graphique ON partage une surface adjacente avec tout autre objet graphique ne formant pas un groupe avec lui, ladite surface adjacente partagée étant normale à l'axe gravitationnel z. En l'espèce, sur l'exemple de la figure 12, l'objet ON « repose », à l'instant t3, sur l'objet graphique O2 et occupe une nouvelle altitude virtuelle AVN3.

La figure 13 décrit la scène présentée par la figure 9 après que l'objet graphique O1 ait été de nouveau sélectionné par l'utilisateur U, ladite nouvelle sélection étant postérieure au déplacement de l'objet graphique ON qui vient d'être décrit en lien avec la figure 12. La figure 13 permet d'illustrer l'apport de l'invention en termes d'aide continue et adaptative pour l'utilisateur U. En effet, l'application de l'étape 130 à l'issue de la nouvelle sélection 110 de l'objet Oi=O1, provoque le calcul 133a de nouvelles projections desdits objets O1 à ON dans le plan PR. Ces nouvelles projections sont représentées par la partie droite VP de la figure 13. Une mise en œuvre de l'opération géométrique 133b ou 133c enseigne que ledit objet ON appartient automatiquement, c'est-à-dire sans que l'utilisateur n'ait eu à renseigner le procédé 100, au groupe GOi=GO1. Une future opération graphique appliquée audit objet graphique O1, emporterait l'application de ladite opération graphique 140b sur l'ensemble des objets graphiques O1, O2, O3 et ON formant un tel nouveau groupe GO1.

Une telle application 140b commune à plusieurs objets graphiques formant un groupe est illustrée par les figures 10 et 6 précédemment évoquées. Selon cet exemple, l'objet graphique Oi=O1 a été préalablement sélectionné en une étape 110 d'un procédé 100 selon la figure 6, par la réception d'une première entrée UE1 de l'utilisateur U. Une deuxième entrée UE2 est réceptionnée par l'unité de traitement 10 mettant en œuvre ledit procédé 100 en une étape 120. Le déplacement du pointeur GP, préalablement positionné sur l'objet graphique O1, accompagné de la réception d'une donnée de confirmation d'action ClickL, est interprété comme une désignation d'une opération graphique Fk=F1 de déplacement d'objets graphiques dans le référentiel d'affichage RA. L'étape 130 ayant conclu à l'existence d'un groupe d'objets graphiques GOi=GO1, ladite opération de déplacement F1 de l'objet O1 emporte l'application de cette même opération de déplacement F1 aux objets graphiques formant ledit groupe GO1, en l'espèce les objets O2 et O3. Comme évoqué précédemment en lien avec les figures 12 et 13, la désignation de l'opération graphique F1 entraîne l'élévation de l'assemblage formé par les objets graphiques O1, O2 et O3 du groupe GO1 de sorte que celui-ci occupe la plus haute altitude virtuelle possible. De cette manière, un tel déplacement conjugué desdits objets graphiques O1, O2 et O3 formant le groupe GO1, permet à l'assemblage ainsi formé d'éventuellement survoler d'autres objets graphiques parmi lesquels l'objet graphique ON comme le montre la figure 10. A l'issue du nouveau positionnement stable dudit assemblage et dès que l'objet O1 n'est plus sélectionné, un déplacement automatique dudit assemblage, constitué par les objets graphiques O1, O2 et O3 formant le groupe GO1, est provoqué, selon une direction opposée à celle de l'axe gravitationnel z, jusqu'à ce que l'objet O1 « entre en collision » ou vienne à partager une surface, normale à l'axe gravitationnel z, avec l'objet ON. Ledit assemblage est ainsi « posé » sur ce dernier comme l'indiquent les vues VD et VC de la figure 10. En l'absence d'un tel objet graphique ON, les objets graphiques O1, O2 et O3, auraient recouvré respectivement les altitudes virtuelles préalables à l'application conjointe 140b de l'opération graphique de déplacement F1 désignée par l'utilisateur.

Décrivons à présent, en lien avec les figures 6 et 16 à 21, une application 140b d'une opération graphique Fk=F2 visant à étirer ou compresser un objet graphique Oi , lorsque ce dernier forme éventuellement un groupe GOi d'objets graphiques par l'application de l'opération géométrique 133d précédemment décrite en lien avec la figure 6. Une telle opération graphique F2 peut être désignée par l'utilisateur U en positionnant le pointeur graphique GP sur l'une des poignées ou taquets DT affichés conjointement avec un objet graphique sélectionné, comme l'indique la figure 8. Une telle opération F2 peut en outre être également désignée via un menu graphique GM ou encore par la sélection de l'un des pictogrammes MC, si ces derniers sont disponibles, en périphérie dudit objet graphique sélectionné Oi. Les figures 16 à 21 illustrent respectivement différentes applications d'une telle opération graphique F2 à des objets graphiques d'un contenu numérique CN d'ores et déjà présenté en lien avec les figures 14 et 15. Comme évoqué précédemment en lien avec la figure 15, pour illustrer la mise en œuvre de l'opération géométrique 133d, la sélection de l'objet graphique O1 enseigne que les objets graphiques O1 et O2 forment un groupe. Pour rappel, cette constitution automatique du groupe GO1 découle de la détection 133d d'un tronçon commun entre les périmètres respectifs P1 et P2 des projections, selon l'axe gravitationnel z dans le plan PR comprenant les axes x et y du référentiel d'affichage RA, des objets graphiques O1 et O2. Les projections des objets O2, O3 et ON ne présentant pas un tel tronçon commun avec le périmètre P1 de la projection de l'objet sélectionné O1, ils n'appartiennent pas audit groupe GO1.

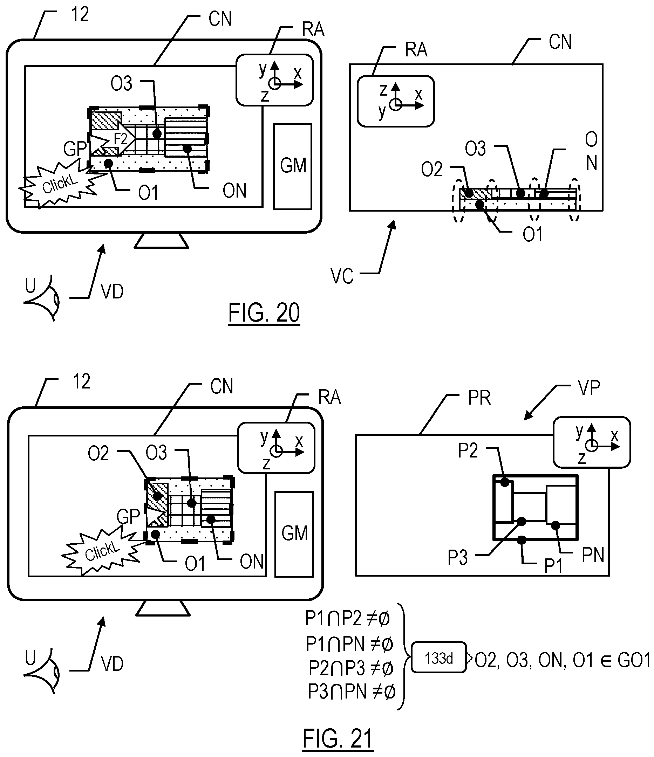

En lien avec la figure 6, la figure 16 décrit un contenu numérique CN similaire à celui présenté par lesdites figures 14 et 15. Elle permet d'illustrer la détection 120 de la désignation d'une opération graphique F2 par l'utilisateur U, ce dernier ayant initialement positionné le pointeur graphique GP sur l'une des poignées DT latérales de l'objet graphique O1 puis provoquant un déplacement dudit pointeur GP selon l'axe x du référentiel RA, alors qu'une donnée de confirmation d'action ClickL est délivrée par l'interface homme-machine d'entrée 11. L'étape 130 ayant confirmé l'existence d'un groupe d'objets GOi=GO1, l'application 140b de l'opération graphique F2 visant à compresser l'objet Oi=O1, induit une action sur l'objet graphique Oj=O2. Nous verrons en lien avec les figures 20 et 21 que cette action induite peut consister en la compression dudit objet O2, avantageusement sous certaines conditions. La figure 16 illustre un mode de réalisation préféré selon lequel, ladite action induite n'implique pas une compression F2 mais un déplacement F1, représenté par une flèche en trait discontinu, dudit objet graphique O2, de sorte que les projections respectives des objets O1 et O2 formant le groupe GO1 conservent le tronçon de périmètre qu'elles partagent, les dimensions caractéristiques de l'objet O2 étant conservées. L'application de l'opération F2 au groupe GO1 entraîne ainsi l'application de ladite opération F2 à l'objet graphique O1 et une opération graphique de déplacement F1 à l'objet O2. Ainsi, l'objet graphique O2 demeure positionné sur l'objet graphique O1 et accompagne passivement la diminution des dimensions de l'objet graphique O1 qui le supporte. Ce fonctionnement d'un logiciel conforme à l'invention est particulièrement intuitif pour un humain. En effet, dans un monde réel imaginons des objets O1 et O2 sous la forme d'objets physiques. L'objet O1 serait un plateau rectangulaire véhiculant l'objet O2, une extrémité de ce dernier prenant appui sur le bord gauche dudit plateau. La compression de la longueur du plateau O1 entraînerait un glissement dudit objet O2 sur ledit plateau, sans pour autant que les dimensions de l'objet O2 ne se réduisent, du moins tant que les dimensions du plateau O1 demeurent suffisantes pour pouvoir héberger l'objet O2. En revanche, une réduction dudit objet O2 serait rendue nécessaire lorsque le plateau O1 aurait atteint les dimensions dudit objet O2 et qu'une compression supplémentaire de l'objet aurait été désignée. Pour éviter que ce dernier ne soit plus intégralement porté par le plateau O1, l'objet O2 devrait à son tour être compressé de sorte que les deux objets O1 et O2 conservent des dimensions compatibles permettant à l'objet O1 de conserver son rôle de support de l'objet O2.

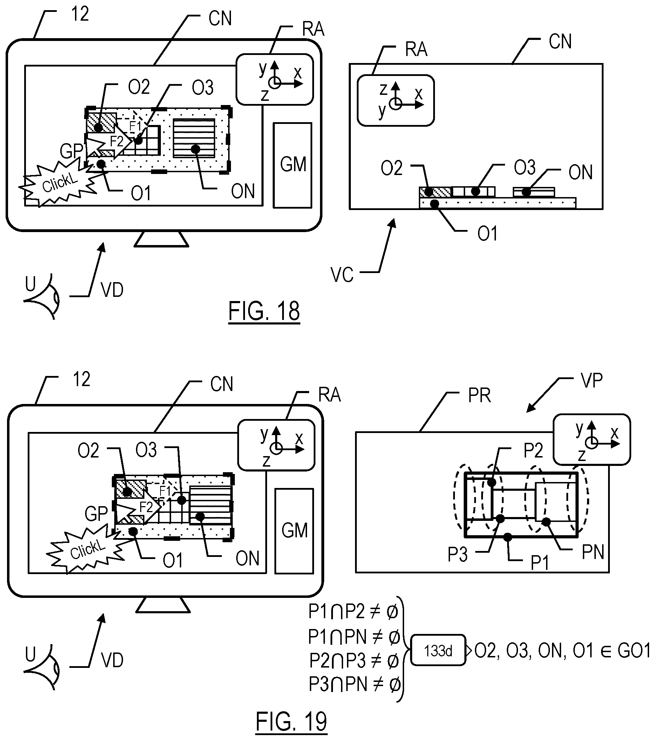

La situation présentée par la figure 17 illustre, dans le contexte de l'invention, une situation selon laquelle la compression de l'objet graphique O1, accompagné par un déplacement de l'objet graphique O2, formant un groupe avec ledit objet graphique O1, entre en collision avec l'objet graphique O3, lui-même positionné sur l'objet graphique O1. Les projections des objets graphiques O1 à ON dans le plan PR sont illustrées par la partie droite VP de la figure 17. Nous pouvons constater que seule la projection de l'objet O2 partage un tronçon de périmètre P2 avec le périmètre P1 de la projection de l'objet graphique O1. En revanche, ladite figure 17 enseigne en outre que l'application induite d'une opération de déplacement F1 à un premier objet graphique Oi emporte un déplacement conjugué de tout autre objet graphique Oj formant un groupe GOi avec ledit premier objet graphique Oi par la mise en œuvre de l'opération géométrique 133d à l'étape 130. Ainsi, sur la figure 17, les projections des objets graphiques O2 et O3 partagent un tronçon de périmètres P2 et P3 cerclé par une ligne discontinue. L'objet graphique O3 forme donc un groupe GO2 avec l'objet graphique O2. Par l'application conjuguée des opérations graphiques F2 et F1, respectivement aux groupes GO1 et GO2, l'objet graphique O3 suit le déplacement de l'objet graphique O2 provoquée par la compression de l'objet graphique O1 comme l'illustre la figure 18 décrivant des vues VD et VC présentant respectivement l'édition courante du contenu numérique CN perçue par l'utilisateur U et une vue en coupe théorique dudit contenu numérique CN décrivant les altitudes virtuelles de chaque objet graphique.

La figure 19 est similaire à la figure 17. Elle enseigne que l'utilisateur U poursuit sa volonté de compresser l'objet graphique O1. L'objet graphique O2 se déplaçant, par l'application induite de l'opération graphique F1 au groupe GO2, finit par entrer en collision avec l'objet graphique ON également véhiculé par l'objet graphique O1. A l'instar de l'objet O3 qui a rejoint un groupe GO2 associé à l'objet graphique O2, l'objet graphique ON rejoint un groupe GO3 auquel appartient l'objet O3, leurs projections respectives dans le plan PR partageant un tronçon de périmètre également cerclé par une ligne discontinue. Le déplacement de l'objet O2, induit par la compression de l'objet graphique O1, lui-même provoquant un déplacement de l'objet O3, entraînant à son tour un déplacement induit de l'objet graphique ON, provoque la scène illustrée par les figures 19 et 20, selon lesquelles l'objet ON devient aligné avec l'une des extrémités de l'objet graphique O1, ladite extrémité étant opposée à celle alignée avec un bord de l'objet O2. Les objets graphiques O2, O3 et ON deviennent dès lors adjacents deux à deux, formant une chaîne dont la longueur est celle de l'objet graphique O1 qui les supporte. Dans ce cas, l'opération géométrique 133d peut être agencée pour indiquer que les objets O1 à ON forment un groupe GO1 associé à l'objet graphique O1. Dans ce cas, l'invention prévoit que l'opération graphique F2 visant à compresser ou étirer l'objet graphique O1 emporte l'application de ladite opération graphique F2 aux objets graphiques appartenant audit groupe GO1. Comme l'indique la figure 21, chaque objet graphique dudit groupe verra ses dimensions modifiées proportionnellement à celles de l'objet graphique support O1. Cette application commune de l'opération graphique F2 à l'ensemble des objets graphiques est illustrée par la figure 21. Ainsi, les vues VD et VP montrent, en l'espèce, la compression proportionnelle des objets O2 à ON à la compression de l'objet O1. En variante, l'étape 133 peut également consister à produire un groupe d'objets graphiques GOi associé à un objet graphique sélectionné Oi, de sorte que ledit groupe GOi soit constitué de manière quelque peu différente. Reprenons l'exemple de la séquence des opérations décrites en lien avec les figures 15 à 21. Lorsque les projections des objets Oi=O1 et O2 partagent en partie leurs périmètres respectifs P1 et P2, l'étape 130 constitue un groupe GOi=GO1 comprenant l'objet O1 et O2. Dans le cadre de cette variante, l'invention prévoit que ladite opération géométrique 133d examine en outre si la projection de l'objet O2 partage une partie de périmètre avec une ou plusieurs autres projections d'objets graphiques tiers, ces derniers venant former également ledit groupe GOi dans l'affirmative. Il n'est rien au stade décrit par la figure 15. En revanche, la figure 17 indique que les objets graphiques O2 et O3 deviennent adjacents à leur tour. Ainsi, les projections desdits objets graphiques O2 et O3, dans le plan PR selon l'axe z, partagent un tronçon de périmètre. L'opération géométrique 133d atteste l'existence d'un groupe d'objet GOi = GO1 formé par les objets graphiques O1, O2 et O3. Au stade d'édition du contenu numérique CN illustré par la figure 19, les objets O3 et ON deviennent alors également adjacents. Les projections desdits objets graphiques O3 et ON, dans le plan PR selon l'axe z, partagent un tronçon de périmètre. L'opération géométrique 133d atteste l'existence d'un groupe d'objets GOi = GO1 formé par les objets O1, O2, O3, ON et à nouveau O1 puisque les projections des objets ON et O1 partagent, elles-mêmes un tronçon de périmètres PN, P1. Pour reprendre la métaphore de la « chaîne » exprimée précédemment, le groupe GO1, que nous pourrions jusqu'alors qualifier de groupe « ouvert », comme l'indique la figure 18 par exemple, devient un groupe d'objets graphiques « fermé », comme l'indique la figure 19, puisque l'objet sélectionné Oi=O1 apparaît plus d'une fois dans ledit groupe GO1 constitué à l'étape 133. Selon cette variante de réalisation, l'application 140 de l'opération Fk=F2 à l'objet O1 emporte l'application de ladite opération F2 aux objets graphiques O1 à ON, les dimensions de ces derniers étant, à leur tour, modifiées comme le décrit la situation illustrée par la figure 21. Ainsi, l'application de l'opération graphique F2, pour étirer ou compresser un objet graphique sélectionné, ne s'applique aux objets d'un groupe comprenant ledit objet graphique sélectionné que lorsque ledit groupe devient fermé, attestant d'une chaîne comme exprimée précédemment.

A titre avantageux, l'invention prévoit qu'un objet graphique Oi puisse être associé à un attribut dont la valeur est inscrite dans la mémoire de données 14 d'un système 1 mettant en œuvre un procédé 100 conforme à l'invention. Un tel attribut peut décrire une première valeur déterminée signifiant que les dimensions caractéristiques, dans le référentiel d'affichage RA, dudit objet graphique soient conservées quelle que soit l'opération graphique Fk appliquée en 140, individuellement 140a ou collectivement 140b. En l'espèce si, par exemple l'objet graphique O3 était concerné par un tel attribut signifiant une conservation de ses dimensions caractéristiques, seuls les objets O2 et ON seraient compressés ou étirés proportionnellement à l'objet graphique O1.

En variante ou en complément, un tel attribut peut décrire une deuxième valeur déterminée signifiant que la position, dans le référentiel d'affichage RA, du centre dudit objet graphique doit être conservée quelle que soit l'opération graphique Fk appliquée en 140, individuellement 140a ou collectivement 140b. En l'espèce si, par exemple l'objet graphique O3 était concerné par un tel attribut signifiant une conservation de sa position dans le référentiel d'affichage RA, les objets O1, O2, O3 et ON seraient compressés ou étirés proportionnellement à l'objet graphique O1 sans qu'un déplacement de l'objet graphique O3 soit induit par l'application de toute opération graphique Fk sur le contenu numérique CN. Un tel attribut pourrait en outre décrire d'autres valeurs déterminées signifiant chacune une invariance d'une caractéristique d'un objet graphique, de sorte que celle-ci soit conservée quelle que soit l'opération graphique Fk appliquée en 140, individuellement 140a ou collectivement 140b.

Comme l'indique la figure 6, un procédé 100 peut comporter une sous-étape 132 pour conditionner les mises en œuvre individuelles ou conjointes d'opérations géométriques telles que les opérations 133b, 133c ou 133d précédemment présentées. En effet, un utilisateur U peut décider de manière temporaire ou maintenue de suspendre la constitution automatique de groupes d'objets graphiques. Pour cela, via l'interface homme-machine d'entrée 11 d'un système informatique 1 selon la figure 1, l'utilisateur U peut provoquer l'émission, par ladite interface homme-machine 11, d'une donnée UDS de suspension de constitution d'un groupe. Celle-ci peut être provoquée par l'appui d'une touche déterminée d'un clavier informatique, le choix d'un paramètre de préférence disponible dans un menu graphique GM affiché conjointement avec la vue VD délivrée par une interface homme-machine de sortie 12 ou encore par la sélection d'un des pictogrammes MC affichables en périphérie d'un objet graphique sélectionné. Cette fonctionnalité permet ainsi à l'utilisateur U de modifier, par exemple, l'apparence graphique d'un seul objet graphique sans que cette modification ne soit propagée aux autres objets formant un groupe avec celui-ci. De la même manière, cette fonctionnalité peut permettre, par exemple, de suspendre la mise en œuvre de l'opération géométrique 133d au seul profit d'une opération graphique 133b ou 133c ou réciproquement. Ainsi, il est possible de suspendre les principes de gravité ou d'adhérence pour certains objets graphiques adjacents.

Enfin, l'invention prévoit que le fond ou cadre du contenu numérique CN, au sein duquel sont agencés différents objets graphiques, puisse être considéré comme un objet graphique en tant que tel. Ainsi, lors de la sélection dudit cadre, tout ou partie des objets graphique du contenu numérique CN peut, selon l'opération géométrique choisie en 130, faire partie d'un groupe associé audit cadre. Une application 140 d'une opération graphique Fk, visant par exemple à accroître ou diminuer les dimensions de celui-ci, pourra être automatiquement appliquée, comme étudié précédemment, aux objets graphiques dudit groupe comportant ledit cadre. L'invention propose ainsi une solution particulièrement efficace aux éditeurs de contenus numériques pour qu'ils puissent redimensionner aisément un contenu numérique aux dimensions de différentes interfaces graphiques de sortie par exemple.

L'invention a été décrite principalement au travers des opérations graphiques Fk visant à déplacer ou modifier les dimensions caractéristiques d'objets graphiques. Toute autre opération graphique Fk, appartenant à un ensemble non exhaustif d'opérations graphiques prédéterminées comportant en outre, des opérations graphiques permettant de redimensionner (selon un facteur multiplicatif), supprimer, dupliquer, modifier l'apparence d'un objet graphique, pourrait être appliquée individuellement 104a ou collectivement 140b, à des objets graphiques sans sortir du cadre de la présente invention.

Quel que soit le mode de réalisation de l'invention retenu, il est donc manifeste que celle-ci apporte à tout utilisateur d'un logiciel mettant en œuvre un procédé, tel que le procédé 100 illustré en figure 6, une aide crédible, continue et adaptative à tout contenu numérique durant sa phase d'édition. Quelle que soit l'expertise d'un utilisateur, sa manipulation des objets graphiques est rendue particulièrement intuitive car son action est continuellement dictée par des réflexes découlant du monde réel (gravité, adhésion, etc.). Un tel utilisateur est notamment totalement déchargé de la construction/déconstruction de groupes d'objets graphiques particulièrement fastidieuse et si peu intuitive avec les solutions actuelles. Grâce à l'invention, la construction/ déconstruction de groupes d'objets graphiques devient automatique et transparente pour l'utilisateur au gré de de l'évolution de l'agencement du contenu numérique. Les entrées de l'utilisateur durant sa tâche sont réduites et simplifiées. La conception d'un tel logiciel conforme à l'invention est en outre particulièrement simplifiée et allégée, ne serait-ce que par la suppression des traitements associés à l'interprétation d'entrées de l'utilisateur spécifiques et dédiées pour proposer des constructions et destructions de groupes d'objets graphiques assistées par l'humain et à la gestion des altitudes virtuelles ou des feuilles de calque numériques selon l'état de l'art.

## Revendications

1. Procédé pour mettre en œuvre une opération graphique (F1, Fk, Fm) sur un premier objet graphique (Oi) parmi une pluralité d'objets graphiques (O1, O2, Oi, Oj, ON) affichés conjointement par une interface homme-machine de sortie (12) d'un système informatique (1), ledit procédé (100) étant mis en œuvre par une unité de traitement (10) dudit système informatique (1) comportant en outre une interface homme-machine d'entrée (11), ledit procédé (100) comprenant:
- une étape (110) pour traduire une première entrée (UE1) d'un utilisateur (U) délivrée par l'interface homme-machine d'entrée (11), en sélection dudit premier objet graphique (Oi) ;
- une étape (120) pour traduire une deuxième entrée (UE2) d'un utilisateur (U), délivrée par l'interface homme-machine d'entrée (11), en désignation d'une opération graphique (Fk) à appliquer au premier objet graphique (Oi) ;
- une étape (130) pour rechercher si ledit premier objet (Oi) appartient à un groupe d'objets graphiques (GOi) parmi la pluralité d'objets graphiques conjointement affichés ;
- une étape (140) pour appliquer ladite opération graphique désignée (Fk) au groupe d'objets graphiques (O1, O2, Oi, Oj, ON) lorsqu'un tel groupe (GOi) d'objets graphiques existe ou au seul premier objet graphique (Oi) dans le cas contraire ;
- une étape (150) pour provoquer un nouvel affichage conjoint de la pluralité des objets graphiques (O1, O2, Oi, Oj, ON) résultant de l'application de ladite opération graphique désignée (Fk) ;
ledit procédé (100) étant **caractérisé en ce que** l'étape (130) pour rechercher si ledit premier objet graphique (Oi) appartient à un groupe d'objets graphiques (GOi) consiste à :
- déterminer (131) un axe (z), dit « axe gravitationnel », au sein d'un référentiel d'affichage (RA) de la pluralité d'objets graphiques ;
- mettre en œuvre une opération géométrique portant sur les projections de premier (Oi) et deuxième (Oj) objets graphiques, lesdites projections étant réalisées selon l'axe gravitationnel (z) sur un plan comprenant le (x) ou les autres axes (x,y) constituant le référentiel d'affichage (RA) et considérer (133), parmi la pluralité d'objets graphiques affichés conjointement (O1, O2, Oi, Oj, ON), un deuxième objet graphique (Oj) comme formant un groupe d'objets graphiques (GOi) comportant le premier objet graphique (Oi) selon le résultat de ladite opération géométrique.

2. Procédé selon la revendication précédente, pour lequel l'opération géométrique (133, 133b) portant sur les projections des premier (Oi) et deuxième (Oj) objets graphiques consiste à déterminer si la surface (Sj) définie par la projection du deuxième objet (Oj) est comprise dans la surface (Si) définie par la projection du premier objet graphique (Oi), le deuxième objet graphique (Oj) étant considéré comme formant un groupe d'objets graphiques (GOi) comportant le premier objet graphique (Oi) dans l'affirmative (130y).

3. Procédé selon la revendication 1, pour lequel l'opération géométrique (133, 133c) portant sur les projections des premier (Oi) et deuxième (Oj) objets graphiques consiste à déterminer si la surface (Sj) définie par la projection du deuxième objet graphique (Oj) est majoritairement comprise dans la surface (Si) définie par la projection du premier objet graphique (Oi), le deuxième objet graphique (Oj) étant considéré comme formant un groupe d'objets graphiques (GOi) comportant le premier objet graphique (Oi) dans l'affirmative (130y) .

4. Procédé selon l'une quelconque des revendications précédentes, pour lequel l'opération géométrique (133, 133d) portant sur les projections des premier (Oi) et deuxième (Oj) objets graphiques consiste à déterminer si lesdites projections partagent tout ou partie de leurs périmètres respectifs (Pi, Pj), le deuxième objet graphique (Oj) étant considéré comme formant un groupe d'objets graphiques (GOi) comportant le premier objet graphique (Oi) dans l'affirmative (130y).

5. Procédé selon l'une quelconque des revendications précédentes, pour lequel l'étape (110) pour traduire une première entrée (UE1) d'un utilisateur (U) en sélection du premier objet graphique (Oi) consiste à :
- déterminer la projection, sur un plan déterminé par la surface d'affichage (DS) de l'interface homme-machine de sortie (12) selon un axe du référentiel d'affichage (RA) normal à ladite surface d'affichage (DS), d'un pointeur graphique (GP), positionné par l'utilisateur (U) via l'interface homme-machine d'entrée (11), lors de la réception d'une donnée de confirmation de pointage (ClickC) délivrée par ladite interface homme-machine d'entrée (11) ;
- considérer, comme premier objet graphique sélectionné (Oi), tout objet graphique dont la projection, dans ledit plan déterminé par la surface d'affichage (DS) de l'interface homme-machine de sortie (12) selon l'axe (z) du référentiel d'affichage (RA) normal à ladite surface d'affichage (DS), comprend ladite projection dudit pointeur graphique (GP) dans ledit plan déterminé par la surface d'affichage (DS).

6. Procédé selon la revendication précédente, pour lequel l'étape (120) pour traduire une deuxième entrée (UE2) d'un utilisateur (U) en désignation d'une opération graphique (Fk) consiste à caractériser un déplacement dudit pointeur graphique (GP) dans le référentiel d'affichage (RA) alors qu'une donnée de confirmation d'action (ClickL) est délivrée par ladite interface homme-machine d'entrée (11).

7. Procédé selon la revendication précédente, pour lequel l'étape (120) pour traduire une deuxième entrée (UE2) d'un utilisateur (U) en désignation d'une opération graphique (Fk) consiste préalablement à déterminer un type d'opération graphique (Fk) à mettre en œuvre à partir d'une donnée de sélection d'action délivrée par l'interface homme-machine d'entrée (11).

8. Procédé selon l'une quelconque des revendications précédentes, pour lequel l'application de l'opération graphique désignée au premier objet graphique sélectionné (Oi) emporte une même application de ladite opération graphique à tout autre deuxième objet graphique (Oj) formant un groupe d'objets graphiques (GOi) comportant le premier objet graphique (Oi), les positions relatives entre lesdits objets graphiques formant ledit groupe étant maintenues durant l'application de ladite opération graphique (Fk).

9. Procédé selon la revendication précédente, pour lequel, lorsqu'une une opération graphique « déplacer » (F1) au sein du référentiel d'affichage (RA) est désignée pour être appliquée au premier objet graphique sélectionné (Oi) et à tout autre deuxième objet graphique (Oj) formant un groupe comportant ledit premier objet graphique (Oj), si ledit groupe (GOi) existe, les positions relatives entre lesdits premier et deuxième objets (Oi, Oj) formant ledit groupe (GOi) sont conservées durant ledit déplacement (Fk).

10. Procédé selon la revendication précédente, pour lequel une opération graphique « déplacer » selon une direction opposée à l'axe gravitationnel (z), s'applique, dès que le premier objet graphique (Oi) n'est plus sélectionné audit premier objet graphique (Oi) et à tout autre deuxième objet graphique (Oj) formant un groupe (GOi) avec celui-ci, dans la limite selon laquelle lesdits premier et/ou deuxième objets graphiques partagent une surface adjacente avec tout autre troisième objet graphique ne formant pas un tel groupe (GOi), ladite surface adjacente partagée étant normale à l'axe gravitationnel (z).

11. Procédé selon l'une quelconque des revendications précédentes, pour lequel l'opération géométrique (133, 133b, 133c, 133d) portant sur les projections des premier (Oi) et deuxième (Oj) objets graphiques n'est pas mise en œuvre lorsqu'une donnée de suspension de constitution groupe (UDS) est délivrée par l'interface homme-machine d'entrée (11).

12. Procédé (100) selon l'une quelconque des revendications précédentes, pour lequel l'opération graphique (Fk, F1, F2) appartient à un ensemble d'opérations graphiques prédéterminées comportant déplacer, redimensionner, supprimer, dupliquer, comprimer, étirer un objet graphique.

13. Produit programme d'ordinateur (P) comportant des instructions de programme qui, lorsqu'elles sont préalablement enregistrées dans une mémoire de programmes (13) d'un système informatique (1) comportant une unité de traitement (10) puis exécutées ou interprétées par ladite unité de traitement (10), provoquent la mise en œuvre d'un procédé selon l'une quelconque des revendications 1 à 12.

14. Support de mémoire de données lisible par un ordinateur enregistrant les instructions d'un produit programme d'ordinateur selon la revendication précédente.

15. Système informatique (1) comportant une unité de traitement (10), une mémoire de programmes (13), une interface homme-machine d'entrée (11), une interface homme-machine de sortie (12), ledit système étant **caractérisé en ce qu'**il comporte, dans ladite mémoire de programmes (3), les instructions d'un produit programme d'ordinateur (P) selon la revendication 13.
